# EUROPEAN PATENT APPLICATION

(11) **EP 4 577 005 A1**
(43) Date of publication of application: **25.06.2025**
(21) Application number: 24220470.9
(22) Date of filing: 17.12.2024
(51) Int. Cl.: H10H 20/851, H10H 20/80

(54) **LIGHT EMITTING DEVICE**

(30) Priority: 22.12.2023 JP 2023217340; 26.12.2023 JP 2023220052; 31.07.2024 JP 2024124579
(71) Applicant: NICHIA CORPORATION, Tokushima 774-8601 (JP)
(72) Inventor: SHICHIJO, Satoshi, Anan-shi, Tokushima, 774-8601 (JP); HAYASHI, Tatsuya, Anan-shi, Tokushima, 774-8601 (JP); HAYASHI, Yusuke, Anan-shi, Tokushima, 774-8601 (JP)
(74) Representative: Betten & Resch

(57) **Abstract**

A light emitting device includes a wavelength converting member, a light emitting part, and a light adjusting member. The wavelength converting member includes an upper surface, a lower surface, a first lateral surface located between the upper surface and the lower surface, and a second lateral surface located between the upper surface and the lower surface, and located opposite to the first lateral surface. The light emitting part includes a light emitting layer, and is disposed below the lower surface of the wavelength converting member and in a region closer to the first lateral surface than to the second lateral surface. The light adjusting member is disposed on the upper surface of the wavelength converting member and in a region closer to the second lateral surface than to the first lateral surface without overlapping with the light emitting layer of the light emitting part in a top view.

## Description

### TECHNICAL FIELD

The present disclosure relates to a light emitting device.

### BACKGROUND

Light emitting elements, such as light emitting diodes (LED), are used as a light source of a vehicle lamp. Japanese Unexamined Patent Publication No. 2017-011259 discloses a light emitting device obtained by combining a plurality of light emitting elements having different areas so that the device has a luminance distribution on its light emitting surface.

### SUMMARY

An object of the present disclosure is to improve light extraction efficiency of a light emitting device having a luminance distribution on a light emitting surface.

A light emitting device includes a wavelength converting member, a light emitting part, and a light adjusting member. The wavelength converting member includes an upper surface, a lower surface, a first lateral surface located between the upper surface and the lower surface, and a second lateral surface located between the upper surface and the lower surface, and located opposite to the first lateral surface. The light emitting part includes a light emitting layer, and is disposed below the lower surface of the wavelength converting member and in a region closer to the first lateral surface than to the second lateral surface. The light adjusting member is disposed on the upper surface of the wavelength converting member and in a region closer to the second lateral surface than to the first lateral surface without overlapping with the light emitting layer of the light emitting part in a top view.

According to an embodiment of the present disclosure, light extraction efficiency of a light emitting device having a luminance distribution on a light emitting surface can be improved.

### BRIEF DESCRIPTION OF THE DRAWINGS

FIG. 1 is a top view schematically illustrating an example of an overall configuration of a light emitting device according to a first embodiment;
FIG. 2 is a cross-sectional view schematically illustrating a cross section taken along line II-II of FIG. 1;
FIG. 3 is a schematic cross-sectional view for explaining an example of an action of the light emitting device according to the first embodiment;
FIG. 4 is a cross-sectional view schematically illustrating a method for manufacturing the light emitting device according to the first embodiment;
FIG. 5 is a cross-sectional view schematically illustrating the method for manufacturing the light emitting device according to the first embodiment;
FIG. 6 is a cross-sectional view schematically illustrating the method for manufacturing the light emitting device according to the first embodiment;
FIG. 7 is a cross-sectional view schematically illustrating the method for manufacturing the light emitting device according to the first embodiment;
FIG. 8 is a cross-sectional view schematically illustrating the method for manufacturing the light emitting device according to the first embodiment;
FIG. 9 is a cross-sectional view schematically illustrating the method for manufacturing the light emitting device according to the first embodiment;
FIG. 10 is a cross-sectional view schematically illustrating the method for manufacturing the light emitting device according to the first embodiment;
FIG. 11 is a cross-sectional view schematically illustrating a light emitting device according to a modification of the first embodiment;
FIG. 12 is a cross-sectional view schematically illustrating another modification of the first embodiment;
FIG. 13 is a cross-sectional view schematically illustrating an example of an overall configuration of a light emitting device according to a second embodiment;
FIG. 14 is a schematic cross-sectional view for explaining an example of an action of the light emitting device according to the second embodiment;
FIG. 15 is a cross-sectional view schematically illustrating an example of an overall configuration of a light emitting device according to a third embodiment;
FIG. 16 is a cross-sectional view schematically illustrating a light emitting device according to a modification of the third embodiment;
FIG. 17 is a cross-sectional view schematically illustrating an example of an overall configuration of a light emitting device according to a fourth embodiment;
FIG. 18 is a cross-sectional view schematically illustrating a light emitting device according to a modification of the fourth embodiment;
FIG. 19 is a cross-sectional view schematically illustrating an example of an overall configuration of a light emitting device according to a fifth embodiment;
FIG. 20 is a cross-sectional view schematically illustrating a light emitting device according to Comparative Example 1; and
FIG. 21 is a graph illustrating a relative luminance, which is results of optical simulation in Example 1, Example 2, and Comparative Example 1.

### DETAILED DESCRIPTION

Hereinafter, a light emitting device according to an embodiment of the present disclosure will be described in detail with reference to the accompanying drawings. However, the following embodiments are merely examples of a light emitting device for embodying the technical idea of the embodiment, and the embodiments are not limited to those described below. The dimensions, materials, shapes, relative arrangements, and the like of the constituent elements described in the embodiments are not intended to limit the scope of the present disclosure thereto, and are merely examples for description, unless otherwise specified. The size, positional relationship, and the like of members illustrated in the drawings may be exaggerated for clarity of description. In the following description, the same names and reference numerals denote the same or similar members, and detailed description thereof will be omitted as appropriate. An end view showing only a cut surface may be used as a sectional view.

In the accompanying drawings, directions may be indicated with reference to an X-axis, a Y-axis, and a Z-axis. The X-axis, the Y-axis, and the Z-axis are directions orthogonal to each other. Hereinafter, a direction in which an arrow is directed in the X-axis direction will be denoted as a "+X direction" or a "+X side", and a direction opposite to the +X direction will be denoted as a "-X direction" or a "-X side". A direction in which an arrow is directed in the Y-axis direction will be denoted as a "+Y direction" or a "+Y side", and a direction opposite to the +Y direction will be denoted as a "-Y direction" or a "-Y side". A direction in which an arrow is directed in the Z-axis direction will be denoted as a "+Z direction" or a "+Z side", and a direction opposite to the +Z direction will be denoted as a "-Z direction" or a "-Z side". In addition, the expression "in a top view" in the embodiments means that an object is viewed from the +Z direction side. These definitions however do not limit the orientation of the light emitting device when used, and the orientation of the light emitting device can be discretionarily determined. In the embodiments, a surface in the +Z direction (that is, a surface of a target object when viewed from the +Z direction side) is referred to as an "upper surface", and a surface in the -Z direction (that is, a surface of a target object when viewed from the -Z direction side) is referred to as a "lower surface". In the embodiments described in the following, "along the X-(Y-, or Z-) axis" includes a case where the object has a tilt within a range of ±10° with respect to the X-(Y-, or Z-)axis. In the embodiments, the term "orthogonal" may include a tolerance within ±10° with respect to 90°.

In the present disclosure, unless otherwise specified, a polygonal shape, such as a rectangular shape, is referred to as a polygonal shape including a shape obtained by performing machining, such as corner rounding, chamfering, corner cutting, or round cutting on the corners of the polygonal shape. Furthermore, the term "polygonal shape" not only encompasses polygonal shapes in which corners (ends of sides) are machined, but also encompasses polygonal shapes in which intermediate portions of the sides are machined. In other words, shapes that are based on polygonal shapes and partially machined are construed as a "polygon" described in the present disclosure.

The above definition of the shape is not only applied to polygons but to any terms representing specific shapes, such as a trapezoid, a circle, and a projection and a recess. The same applies to the terms related to the sides forming the shape. In other words, even if a corner or an intermediate portion of a certain side is processed, the interpretation of the term "side" includes the processed portion.

The term "cover" or "covering" is not limited to a case of a direct covering, and includes a case of an indirect covering, for example, a case where an object is covered with another member interposed therebetween. The term "disposed" is not limited to a case of a direct disposition, and includes a case of an indirect disposition, for example, a case where an object is disposed with another member interposed therebetween.

### (First Embodiment)

### <Overall Configuration Example of Light Emitting Device 1>

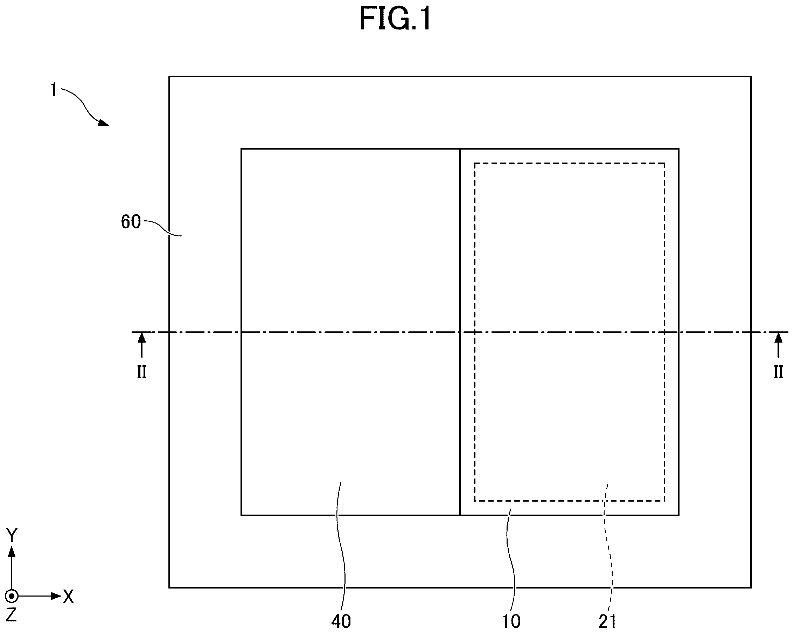

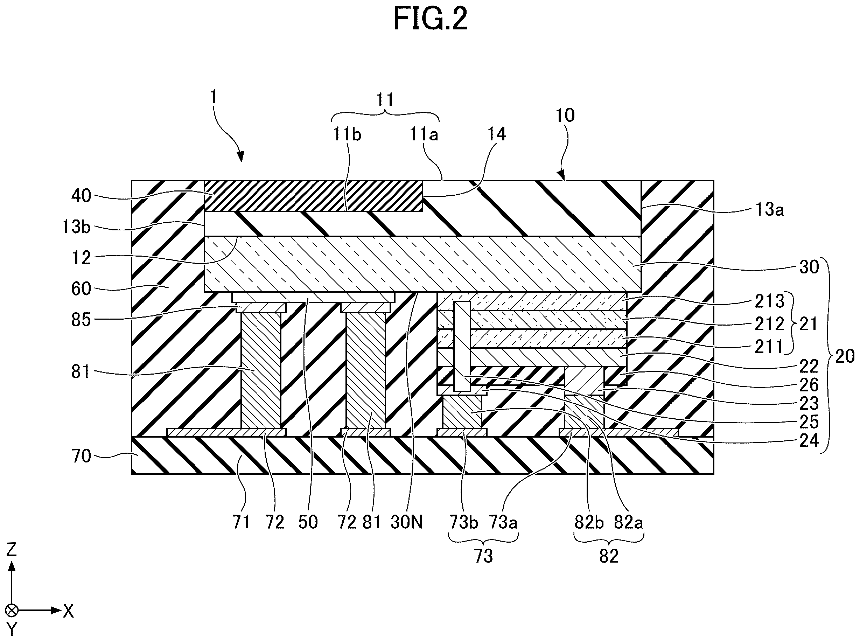

An example of an overall configuration of a light emitting device 1 according to the first embodiment is described with reference to FIGS. 1 and 2. FIG. 1 is a top view schematically illustrating an example of an overall configuration of the light emitting device 1 according to the first embodiment. FIG. 2 is a cross-sectional view schematically illustrating a cross section taken along line II-II of FIG. 1.

In the example illustrated in FIGS. 1 and 2, the light emitting device 1 includes: a wavelength converting member 10; a light emitting element 20 including a light emitting part 21 and a light transmissive member 30; and a light adjusting member 40. The light emitting element 20 does not have to include the light transmissive member 30. In the case where the light emitting element 20 does not include the light transmissive member 30, the light emitting device 1 includes the wavelength converting member 10, the light emitting part 21, and the light adjusting member 40. The light emitting device 1 can further include a light reflective film 50, a covering member 60, a wiring substrate 70, and bonding members 81 and 82. The light emitting device 1 does not have to include the bonding members 81.

### <Wavelength Converting Member 10>

The configuration of the wavelength converting member 10 is described. The wavelength converting member 10 converts a wavelength of at least part of light emitted from the light emitting part 21. As illustrated in FIG. 2, the wavelength converting member 10 has an upper surface 11, a lower surface 12, a first lateral surface 13a, and a second lateral surface 13b.

In the example illustrated in FIG. 2, the upper surface 11 has a first upper surface 11a and a second upper surface 11b. The first upper surface 11a is located on the +X side relative to to the second upper surface 11b. The second upper surface 11b is located below relative to the first upper surface 11a (i.e., located on the -Z side). In the wavelength converting member 10, the thickness from the second upper surface 11b to the lower surface 12 is smaller than the thickness from the first upper surface 11a to the lower surface 12.

The first upper surface 11a and the second upper surface 11b are connected via the inner wall surface 14. As illustrated in FIG. 2, the inner wall surface 14 connects the -X-side outer edge of the first upper surface 11a and the +X-side outer edge of the second upper surface 11b. The first upper surface 11a, the inner wall surface 14, and the second upper surface 11b define a stepped region in the upper surface 11 of the wavelength converting member 10.

In the example illustrated in FIG. 2, the inner wall surface 14 is located on the -X side relative to the light emitting part 21 in a top view. In other words, the second upper surface 11b does not overlap with the light emitting part 21 in a top view.

In the example illustrated in FIG. 2, the upper surface 11 of the wavelength converting member 10 includes a plurality of regions located at different positions in the Z-axis direction with respect to the lower surface 12, such as the first upper surface 11a and the second upper surface 11b. However, the present embodiment is not limited to this example. For example, the upper surface 11 of the wavelength converting member 10 may be a flat surface parallel to the X-axis direction and the Y-axis direction.

The first lateral surface 13a is disposed between the upper surface 11 and the lower surface 12. The first lateral surface 13a illustrated in FIG. 2 connects the +X-side outer edges of the first upper surface 11a and the lower surface 12 to each other. The first lateral surface 13a is a +X-side lateral surface of the wavelength converting member 10. The second lateral surface 13b is disposed between the upper surface 11 and the lower surface 12 and located opposite to the first lateral surface 13a. The second lateral surface 13b illustrated in FIG. 2 connects the -X-side outer edges of the second upper surface 11b and the lower surface 12 to each other. The second lateral surface 13b is a -X-side lateral surface of the wavelength converting member 10.

In the example illustrated in FIG. 1, the wavelength converting member 10 has a rectangular shape in a top view. The wavelength converting member 10 may have a different shape, such as a circular shape or a polygonal shape, in a top view.

The wavelength converting member 10 contains a phosphor. Examples of the phosphor include: oxynitride-based phosphors, such as yttrium-aluminum-garnet-based phosphors (e.g., (Y, Gd)₃(Al, Ga)₅O₁₂:Ce), lutetium-aluminum-garnet-based phosphors (e.g., Lu₃(Al, Ga)₅O₁₂:Ce), terbium-aluminum-garnet-based phosphors (e.g., Tb₃(Al, Ga)₅O₁₂:Ce), CCA-based phosphors (e.g., Ca₁₀(PO₄)₆Cₗ₂:Eu), SAE-based phosphors (e.g., Sr₄Al₁₄O₂₅:Eu), chlorosilicate-based phosphors (e.g., Ca₈MgSi₄O₁₆Cl₂:Eu), silicate-based phosphors (e.g., (Ba, Sr, Ca, Mg)₂SiO₄:Eu), β-sialon-based phosphors (e.g., (Si, Al)₃(O, N)₄:Eu), and α-sialon-based phosphors (e.g., Ca(Si, Al)₁₂(O, N)₁₆:Eu); nitride-based phosphors, such as LSN-based phosphors (e.g., (La, Y)₃Si₆N₁₁:Ce), BSESN-based phosphors (e.g., (Ba, Sr)₂Si₅N₈: Eu), SLA-based phosphors (e.g., SrLiAl₃N₄:Eu), CASN-based phosphors (e.g., CaAlSiN₃:Eu), and SCASN-based phosphors (e.g., (Sr, Ca) AlSiN₃:Eu); nitride-based phosphors, such as KSF-based phosphors (e.g., K₂SiF₆:Mn), KSAF-based phosphors (e.g., K₂(Si_{1-X}Al_{X})F_{6-X}:Mn, herein x satisfies 0 < x < 1), MGF-based phosphors (e.g., 3.5MgO·0.5MgF₂·GeO₂:Mn); quantum dots having a perovskite structure (e.g., (Cs, FA, MA)(Pb, Sn)(F, Cl, Br, I)₃, herein FA and MA represent formamidinium and methylammonium, respectively); group II-VI quantum dots (e.g., CdSe); group III-V quantum dots (e.g., InP); quantum dots having a chalcopyrite structure (e.g., (Ag, Cu) (In, Ga) (S, Se)₂), or the like.

For example, in the case where the light from the light emitting part 21 is blue light and the phosphor is an yttrium-aluminum-garnet-based phosphor (hereinafter referred to as a "YAG phosphor") that is excited by the blue light and converts the light into yellow light, the blue light emitted by the light emitting part 21 and the yellow light wavelength-converted by the YAG phosphor are mixed, and white light can be thereby extracted from the light emitting device 1.

The wavelength converting member 10 may contain a light diffusing substance or does not have to contain a light diffusing substance. Examples of the light diffusing substance include titanium oxide, barium titanate, aluminum oxide, silicon oxide, and yttrium aluminum perovskite (YAP) .

### <Light Emitting Element 20>

Next, the configuration of the light emitting element 20 is described. The light emitting element 20 is a semiconductor light emitting element, such as a light emitting diode (LED) or a laser diode (LD). In the example illustrated in FIG. 2, the light emitting element 20 includes: the light transmissive member 30, the light emitting part 21 including a light emitting layer 212, a first electrode 22, a first pad electrode 23, a second pad electrode 24, a second electrode 25, and an insulating layer 26. The first electrode 22, the first pad electrode 23, the second pad electrode 24, the second electrode 25, and the insulating layer 26 are arranged on the side where the lower surface of the light emitting element 20 is (i.e., on the lower surface of the light emitting part 21).

As illustrated in FIG. 1, the light emitting part 21 overlaps with the wavelength converting member 10 in a top view. Specifically, the light emitting part 21 is disposed below the lower surface 12 of the wavelength converting member 10 in a region closer to the first lateral surface 13a. In other words, in the light emitting device 1, in a top view, the center of the light emitting part 21 is located further in the +X direction of the wavelength converting member 10 than the center of the wavelength converting member 10.

The light emitting part 21 illustrated in FIG. 1 has a rectangular shape in a top view. The light emitting part 21 may have a different shape, such as a square, a circle, or a polygon, in a top view.

The light emitting part 21 includes a first semiconductor layer 211, a light emitting layer 212, and a second semiconductor layer 213. The first semiconductor layer 211 is disposed on the lower surface of the light emitting layer 212. The second semiconductor layer 213 is disposed on the upper surface of the light emitting layer 212. In other words, the light emitting part 21 includes at least one layer stack in which the second semiconductor layer 213, the light emitting layer 212, and the first semiconductor layer 211 are disposed in this order from the wavelength converting member 10 side. The light emitting layer 212 may have a single quantum well (SQW) structure or a multiple quantum well (MQW) structure including a plurality of well layers. The first semiconductor layer 211 is a p-side semiconductor layer. The second semiconductor layer 213 is an n-side semiconductor layer.

Each of the first semiconductor layer 211, the light emitting layer 212, and the second semiconductor layer 213 may be a semiconductor layer formed of a nitride semiconductor. A nitride semiconductor includes a semiconductor having all compositions in which composition ratios x and y are changed within respective ranges in a chemical formula InₓAl_{y}Ga_{1-x-y}N (0 ≤ x, 0 ≤ y, x + y ≤ 1) . The emission peak wavelength of the light emitting layer 212 can be appropriately selected according to the purpose. The light emitting layer 212 is configured to be capable of emitting, for example, visible light or ultraviolet light.

In the case where a structure including the first semiconductor layer 211, the light emitting layer 212, and the second semiconductor layer 213 constitutes one layer stack, the light emitting part 21 can include a plurality of layer stacks. In such a case, for example, multiple layer stacks overlap in the Z-axis direction. In the light emitting layer 212 included in each of the plurality of layer stacks, the light emitting part 21 may include well layers having different emission peak wavelengths or may include well layers having the same emission peak wavelength. The same emission peak wavelength includes a case where there is a variation of about several nanometers.

A combination of emission peak wavelengths of a plurality of layer stacks can be selected as appropriate. For example, in the case where the light emitting part 21 includes two layer stacks, examples of a combination of light emitted from the light emitting layers of the layer stacks include combinations of: blue light and blue light; green light and green light; red light and red light; ultraviolet light and ultraviolet light; ultraviolet light and blue light; blue light and green light; blue light and red light; green light and red light; and the like. For example, in the case where the light emitting part 21 includes three layer stacks, a combination of blue light, green light, and red light is given as an example combination of light emitted from the light emitting layers of the layer stacks.

In the example illustrated in FIG. 2, in a top view, the light emitting part 21 overlaps with the first upper surface 11a of the wavelength converting member 10 and does not overlap with the second upper surface 11b. Thus, the light emitting device 1 can make an amount of light emitted from the first upper surface 11a larger than an amount of light emitted from the second upper surface 11b. Accordingly, a light emitting device having a luminance distribution including a high-luminance region and a low-luminance region on the light emitting surface can be obtained. In the case where such a light emitting device 1 is used for a vehicle-mounted headlight, a high luminance region can be arranged at a desired portion in an irradiated region. Accordingly, it is easy to obtain a desired light distribution without using a complicated optical design, such as a reflector or a lens. This enables the headlight to be reduced in size, and to have more flexibility in design. In the light emitting surface of the light emitting device 1, in a top view, the region corresponding to the first upper surface 11a of the wavelength converting member 10 is a high luminance region, and the region corresponding to the upper surface of the light adjusting member 40 is a low-luminance region. The average luminance of the low-luminance region is 20% or more and 80% or less of the average luminance of the high luminance region.

The light emitting part 21 is not limited to the configuration in which the light emitting part 21 overlaps with, in a top view, the first upper surface 11a of the wavelength converting member 10 and does not overlap with, in a top view, the second upper surface 11b; the light emitting part 21 can include a light emitting part overlapping, in a top view, with the first upper surface 11a of the wavelength converting member 10 (hereinafter, may be referred to as a "first light emitting part") and another light emitting part overlapping with, in a top view, the second upper surface 11b of the wavelength converting member 10 (hereinafter, may be referred to as a "second light emitting part"). Each of the first light emitting part and the second light emitting part includes one or more light emitting layers. In the case where the light emitting device 1 includes the first light emitting part and the second light emitting part as the light emitting parts, the quantity of light emitting layers included in the first light emitting part is preferably larger than the quantity of light emitting layers included in the second light emitting part.

The first electrode 22 is electrically connected to the first semiconductor layer 211. The first electrode 22 is disposed on the lower surface of the first semiconductor layer 211. In the case where the first semiconductor layer 211 is a p-side semiconductor layer, the first electrode 22 is a p-side electrode.

Examples of the substance constituting the first electrode 22 include a single metal material, such as gold (Au), silver (Ag), aluminum (Al), nickel (Ni), rhodium (Rh), copper (Cu), titanium (Ti), platinum (Pt), palladium (Pd), molybdenum (Mo), chromium (Cr), or tungsten (W), or an alloy material containing any of these metals. The first electrode 22 may have a single-layer structure formed of a single metal layer, or may have a stacked structure in which a plurality of metal layers are stacked in the Z-axis direction.

As a substance constituting the first electrode 22, a substance having high reflectance, such as Ag or Al, is preferable. With the first electrode 22 being formed of a substance having high reflectance, light emitted downward (that is, to the -Z side) from the light emitting layer 212, for example, can be reflected upward (that is, to the +Z side). In other words, the light that reaches the first electrode 22 can be reflected toward the wavelength converting member 10. This can improve the light extraction efficiency in the light emitting device 1. The term "reflectance" used herein refers to reflectance at an emission peak wavelength of light emitted from the light emitting layer 212.

The first electrode 22 may be formed of a transparent conductive layer, such as indium tin oxide (ITO). The first electrode 22 may have a single-layer structure of only a transparent conductive layer, or may have a stacked structure of a metal layer and a transparent conductive layer in combination with the above-described metal layer (for example, Ag or Al).

The second electrode 25 is electrically connected to the second semiconductor layer 213. As illustrated in FIG. 2, the second electrode 25 passes through the insulating layer 26 and the first electrode 22 and extends to the second semiconductor layer 213. Although not illustrated, an insulating layer is disposed between the second electrode 25 and the light emitting layer 212, between the second electrode 25 and the first semiconductor layer 211, and between the second electrode 25 and the first electrode 22. In the case where the second semiconductor layer 213 is an n-side semiconductor layer, the second electrode 25 is an n-side electrode.

The substance constituting the second electrode 25 may be the same metal material or alloy material as that constituting the first electrode 22, or may be a metal material or alloy material different from that constituting the first electrode 22. The second electrode 25 may have a single-layer structure formed of a single metal layer, or may have a stacked structure in which a plurality of metal layers are stacked in the Z-axis direction.

In the example illustrated in FIG. 2, the first pad electrode 23 is disposed on the lower surface of the first electrode 22. The first pad electrode 23 passes through the insulating layer 26 in the Z-axis direction and extends below the insulating layer 26 (i.e., the -Z side). The substance constituting the first pad electrode 23 is, for example, the same material as that constituting the second electrode 25.

The second pad electrode 24 is disposed on the lower surface of the second electrode 25. The second pad electrode 24 may be bonded to the lower surface of the insulating layer 26. The substance constituting the second pad electrode 24 is, for example, the same material as that constituting the first pad electrode 23.

In the example illustrated in FIG. 2, the insulating layer 26 is disposed between the first electrode 22 and the second pad electrode 24. Interposition of the insulating layer 26 between the first electrode 22 and the second pad electrode 24 can suppress a short circuit between the first electrode 22 and the second pad electrode 24.

The light transmissive member 30 is a member that supports the light emitting part 21. The light transmissive member 30 is disposed between the wavelength converting member 10 and the light emitting part 21. Herein, the term "light transmissive" means that, for example, the transmittance of light emitted from the light emitting layer 212 is 80% or more. Examples of the substance constituting the light transmissive member 30 include insulating materials, such as sapphire, spinel, and glass, and semiconductor materials, such as aluminum nitride and silicon carbide.

As illustrated in FIG. 2, the light transmissive member 30 may be disposed so as to extend to a point of location where the light transmissive member 30 overlaps with the light adjusting member 40 in a top view. In other words, the light transmissive member 30 may overlap, in a top view, each of the first upper surface 11a and the second upper surface 11b of the wavelength converting member 10. Because the light transmissive member 30 is disposed so as to extend to a point of location where it overlaps with the light adjusting member 40 in a top view, light emitted by the light emitting layer 212 can propagate beyond the second lateral surface 13b side of the wavelength converting member 10. The light transmissive member 30 does not have to overlap with the light adjusting member 40 in a top view. In other words, the light transmissive member 30 does not have to overlap with each of the first upper surface 11a and the second upper surface 11b of the wavelength converting member 10 in a top view, and may overlap only with the first upper surface 11a of the wavelength converting member 10 in a top view.

The light transmissive member 30 has an upper surface, a lower surface, and one or more lateral surfaces connecting the outer edges of the upper surface and the lower surface. In the example illustrated in FIG. 2, the position of the lateral surface of the light transmissive member 30 on the -X side coincides with the position of the lateral surface of the wavelength converting member 10 on the -X side in the X-axis direction. In the X-axis direction, the position of the +X-side lateral surface of the light transmissive member 30 coincides with the position of the +X-side lateral surface of the wavelength converting member 10.

In the example illustrated in FIG. 1, the light transmissive member 30 has a rectangular shape in a top view. The light transmissive member 30 may have a different shape, such as a circular shape or a polygonal shape, in a top view.

The upper surface of the light transmissive member 30 and the lower surface of the wavelength converting member 10 may be directly bonded to each other, or may be bonded to each other via another member, such as a light transmissive adhesive member.

### <Light Adjusting Member 40>

Next, the configuration of the light adjusting member 40 is described. The light adjusting member 40 is a member for adjusting optical characteristics, such as an amount and/or chromaticity of light emitted from a low-luminance region of the light emitting device 1. The light adjusting member 40 is disposed on the upper surface 11 of the wavelength converting member 10 in a region closer to the second lateral surface 13b. In the example illustrated in FIG. 2, the light adjusting member 40 does not overlap with the light emitting part 21 in a top view. In the light emitting device 1, the center of the light adjusting member 40 is located further in the -X direction of the wavelength converting member 10 from the center of the wavelength converting member 10 in a top view.

In the example illustrated in FIG. 2, the light adjusting member 40 is disposed on the second upper surface 11b of the wavelength converting member 10. In this case, it is preferable that the position of the upper surface of the light adjusting member 40 coincide with the position of the first upper surface 11a of the wavelength converting member 10 in the Z-axis direction. This can reduce the size of the light emitting device 1. Furthermore, this facilitates alignment with a lens disposed above the light emitting device 1. The position of the upper surface of the light adjusting member 40 in the Z-axis direction may be lower than the position of the first upper surface 11a of the wavelength converting member 10 (i.e., on the -Z-axis direction side).

The light adjusting member 40 has an upper surface, a lower surface located opposite to the upper surface, and a plurality of lateral surfaces located between the upper surface and the lower surface. In the example illustrated in FIGS. 1 and 2, a portion of the wavelength converting member 10 is in contact with one of the plurality of lateral surfaces of the light adjusting member 40, and other portions of the wavelength converting member 10 is not in contact with the other lateral surfaces of the plurality of lateral surfaces of the light adjusting member 40. In other words, the wavelength converting member 10 covers the lateral surface of the light adjusting member 40 facing the inner wall surface 14 of the wavelength converting member 10 among the plurality of lateral surfaces of the light adjusting member 40. Furthermore, the wavelength converting member 10 does not cover the lateral surfaces of the light adjusting member 40 other than the lateral surface of the light adjusting member 40 facing the inner wall surface 14 of the wavelength converting member 10. Hereinafter, "the lateral surface facing the inner wall surface 14 of the wavelength converting member 10 among the plurality of lateral surfaces of the light adjusting member 40" may be referred to as "outer lateral surfaces of the light adjusting member 40".

The light adjusting member 40 transmits some part of light that reaches from the light emitting layer 212 of the light emitting part 21, and reflects some other part. An example of the light adjusting member 40 is a resin containing particles of a light reflective substance. Examples of the resin include a resin containing one or more of a silicone resin, a modified silicone resin, an epoxy resin, a modified epoxy resin, an acrylic resin, a phenol resin, a bismaleimide triazine resin, and a polyphthalamide resin, or a hybrid resin thereof. Among these, a resin containing a silicone resin as a base material, which is good in heat resistance and electrical insulation and has flexibility, is preferable. Examples of the light reflective substance include titanium oxide, silicon oxide, zirconium oxide, magnesium oxide, calcium carbonate, calcium hydroxide, calcium silicate, zinc oxide, barium titanate, potassium titanate, aluminum oxide, aluminum nitride, boron nitride, mullite, and combinations thereof. Among these, titanium oxide is preferable because it is relatively stable against moisture and the like and has a high refractive index. Another example of the light adjusting member 40 is a sintered body including a base member formed of an inorganic material and particles of a light reflective substance contained in the base member. The base member can be formed of, for example, aluminum oxide, yttrium oxide, zirconium oxide, magnesium oxide, or silicon oxide. The particles of the light reflective substance may be formed of one or more of the above-mentioned materials. Another example of the light adjusting member 40 is an inorganic member containing a mixture of boron nitride, silicon oxide, and potassium hydroxide.

The concentration of the light reflective substance of the light adjusting member 40 is preferably, for example, 60 mass% or more and 70 mass% or less. The concentration of the light reflective substance indicates the ratio of the light reflective substance in the light adjusting member 40. The reflectance of the light adjusting member 40 is preferably, for example, 1% or more and 95% or less.

The light adjusting member 40 may contain a phosphor or does not have to contain a phosphor. The phosphor contained in the light adjusting member 40 may be the same as or different from the phosphor contained in the wavelength converting member 10. The light adjusting member 40 containing the phosphor can reduce a difference between chromaticity of the light emitted from the first upper surface 11a of the wavelength converting member 10 and chromaticity of the light emitted from the upper surface of the light adjusting member 40.

<Light Reflective Film 50>

Next, the configuration of the light reflective film 50 is described. The light reflective film 50 is disposed on the lower surface of the light transmissive member 30. Specifically, the light reflective film 50 is disposed on the lower surface of the light transmissive member 30 in the region where the light transmissive member 30 overlaps with the light adjusting member 40 in a top view. In other words, the light reflective film 50 overlaps with the second upper surface 11b of the wavelength converting member 10 in a top view. The light reflective film 50 is disposed on the lower surface of the light transmissive member 30 and at a position separated from the light emitting part 21.

Examples of the light reflective film 50 include a metal film having a high reflectance, such as Ag or Al, and an optical thin film, such as a DBR.

The light reflective film 50 is disposed on the lower surface of the light transmissive member 30 in the region where the light reflective film 50 overlaps with the light adjusting member 40 in a top view, and the light that reaches the light reflective film 50 can thus be reflected toward the light adjusting member 40. This can improve the light extraction efficiency of the light emitting device 1.

### <Covering Member 60>

Next, the configuration of the covering member 60 is described. The covering member 60 preferably has a light blocking property, and more preferably has a light reflective property. In the case where the covering member 60 has a light reflective property, an example of a substance constituting the covering member 60 is a resin containing particles of a light reflective substance. The resin contained in the covering member 60 may be the same as or different from the resin contained in the light adjusting member 40. The covering member 60 preferably has, for example, a reflectance of 60% or more, and more preferably 90% or more, at the emission peak wavelength of the light emitted from the light emitting layer 212. The reflectance of the covering member 60 can be higher than the reflectance of the light adjusting member 40.

The covering member 60 is, for example, a white resin containing titanium oxide and a silicone resin. The covering member 60 is not limited to a white resin, and may be an inorganic member containing a mixture of boron nitride, silicon oxide, and potassium hydroxide. The covering member 60 may be an inorganic member including a sintered body of a paste and silicon oxide or aluminum oxide formed on the surface of or in the gaps of the sintered body. The sintered body may contain titanium oxide, aluminum oxide, and an acrylic resin.

As illustrated in FIG. 2, the covering member 60 covers the first lateral surface 13a and the second lateral surface 13b of the wavelength converting member 10. From the covering member 60,the upper surface 11 of the wavelength converting member 10 is exposed. In the example illustrated in FIG. 2, from the covering member 60, the first upper surface 11a of the wavelength converting member 10 is exposed. Furthermore, from the covering member 60,the upper surface of the light adjusting member 40 is exposed.

Because the first lateral surface 13a and the second lateral surface 13b of the wavelength converting member 10 are covered by the covering member 60, light that reaches the first lateral surface 13a and the second lateral surface 13b can be reflected toward the upper surface 11 of the wavelength converting member 10. This can improve the light extraction efficiency of the light emitting device 1.

The covering member 60 preferably covers a portion 30N of the lower surface of the light transmissive member 30 that does not overlap with the light reflective film 50 in a top view. This allows light that reaches the portion 30N of the lower surface of the light transmissive member 30, to be reflected toward the second upper surface 11b of the wavelength converting member 10.

The covering member 60 preferably covers the outer lateral surfaces of the light adjusting member 40. This allows light that reaches the outer lateral surfaces of the light adjusting member 40 to be reflected toward the second upper surface 11b of the wavelength converting member 10. Accordingly, the light extraction efficiency of the light emitting device 1 can be further improved.

### <Wiring Substrate 70>

Next, the configuration of the wiring substrate 70 is described. The wiring substrate 70 is disposed below (that is, on the -Z side of) the light emitting part 21 and the light reflective film 50. In the example illustrated in FIG. 2, the wiring substrate 70 has a rectangular shape in a top view. However, the wiring substrate 70 may have a different shape, such as a circular shape or a polygonal shape, in a top view.

As illustrated in FIG. 2, the wiring substrate 70 includes a base 71, a first metal layer 72, and a second metal layer 73. The base 71 is a base member of the wiring substrate 70. The base 71 has a rectangular shape in a top view. The base 71 may have a different shape, such as a circular shape or a polygonal shape, in a top view. The base 71 is preferably formed of ceramic having good heat dissipation properties, such as aluminum nitride, aluminum oxide, silicon carbide, or silicon nitride, or resin having good heat dissipation properties, such as glass epoxy.

The first metal layer 72 is disposed on the upper surface of the base 71. In the example illustrated in FIG. 2, the first metal layer 72 includes two metal layers that are arranged side by side in the X-axis direction and spaced apart from each other. The first metal layer 72 is not limited to including two metal layers, and may be one metal layer. The quantity of metal layers included in the first metal layer 72 may be equal to or different from the quantity of bonding members 81 described below. The first metal layer 72 may have a single-layer structure formed of a single metal layer, or may have a stacked structure in which a plurality of metal layers are stacked in the Z-axis direction. The upper surface of the base 71 is an example of the upper surface of the wiring substrate 70.

As illustrated in FIG. 2, each of the first metal layers 72 is bonded to the lower surface of each of the plurality of bonding members 81. The first metal layer 72 functions as a bonding layer for improving the bonding properties between the bonding member 81 and the base 71. Furthermore, the first metal layer 72 can release, to the base 71 side, heat generated in either or both of the wavelength converting member 10 and the light emitting part 21 and transferred to the bonding member 81.

Examples of the substance constituting the first metal layer 72 include a single metal material, such as Au, Ag, Al, Ni, Rh, Cu, Ti, Pt, Pd, Mo, Cr, or W, and an alloy material containing any of these metals.

The second metal layer 73 is disposed on the upper surface of the base 71 at a position separated from the first metal layer 72. The second metal layer 73 illustrated in FIG. 2 includes two metal layers 73a and 73b arranged side by side in the X-axis direction and spaced apart from each other. The second metal layer 73a is electrically connected to the first semiconductor layer 211 via the bonding member 82a, the first pad electrode 23, and the first electrode 22. The second metal layer 73b is electrically connected to the second semiconductor layer 213 via the bonding member 82b, the second pad electrode 24, and the second electrode 25.

The second metal layer 73 is electrically connected to an external power supply. The current from the external power supply is supplied to the light emitting part 21 via the second metal layer 73. The light emitting part 21 performs a light emitting operation by the current supplied via the second metal layer 73. The substance constituting the second metal layer 73 may be the same as or different from the substance of the first metal layer 72. The second metal layer 73 may have a single-layer structure formed of a single metal layer, or may have a stacked structure in which a plurality of metal layers are stacked in the Z-axis direction.

The wiring substrate 70 may include, in the lower surface of the base 71, a metal layer electrically to be connected to the first metal layer 72. The wiring substrate 70 does not have to include a metal layer, in the lower surface of the base, connected to the first metal layer 72. Similarly, the wiring substrate 70 may or may not include, in the lower surface of the base 71, a metal layer electrically to be connected to the second metal layer 73.

### <Bonding Members 81 and 82>

The bonding member 81 connects the first metal layer 72 and the light reflective film 50. This can reduce the possibility that the wavelength converting member 10 is disposed with a tilt with respect to the wiring substrate 70. The bonding member 81 is preferably formed of a substance having high heat dissipation efficiency. The first metal layer 72 and the light reflective film 50 are connected to each other via the bonding member 81, and the heat dissipation efficiency of the light emitting device 1 can be thus improved. The bonding member 81 is an example of a "first bonding member". The bonding member 81 is not necessarily connected to both the first metal layer 72 and the light reflective film 50, and thus need not be connected to either one of the first metal layer 72 or the light reflective film 50.

FIG. 2 illustrates two bonding members 81. The two bonding members 81 are respectively bonded to the two first metal layers 72. However, the quantity of the bonding members 81 bonded to the first metal layer 72 is not limited to two, and may be one, three, or more.

The bonding member 81 includes, for example, at least one of a simple metal material or an alloy material. The metal material and/or the alloy material constituting the bonding member 81 may be the same as or different from those constituting the first metal layer 72. In the case where the bonding member 81 and the first metal layer 72 are formed of the same material, the adhesion between the bonding member 81 and the first metal layer 72 can be improved. The bonding member 81 may be formed of a substance, such as ceramic having high heat dissipation efficiency.

The bonding member 81 may be bonded to the light reflective film 50 via an adhesive layer 85. The adhesive layer 85 is formed of a substance having high heat dissipation efficiency, such as a metal material or an alloy material. By disposing the adhesive layer 85 between the bonding member 81 and the light reflective film 50, the adhesion between the bonding member 81 and the light reflective film 50 can be improved. However, the upper surface of the bonding member 81 and the lower surface of the light reflective film 50 may be directly bonded to each other. In the case of the first embodiment, the adhesive layer 85 may be formed of a substance having conductivity or a substance having no conductivity. In the case of a second embodiment, which is described later, the adhesive layer 85 is formed of a conductive substance.

The bonding member 82 electrically connects the second metal layer 73 and the light emitting part 21. FIG. 2 illustrates two bonding members 82a and 82b. The bonding member 82a electrically connects the second metal layer 73a and the first semiconductor layer 211 via the first pad electrode 23 and the first electrode 22. The bonding member 82b electrically connects the second metal layer 73b and the second semiconductor layer 213 via the second pad electrode 24 and the second electrode 25.

The bonding member 82 includes at least one of a metal material or an alloy material. By connecting the second metal layer 73 of the wiring substrate 70 and the light emitting part 21 via the bonding member 82, it is possible to secure the electrical conductivity of the current path including the second metal layer 73 and the light emitting part 21.

### <Example of Action>

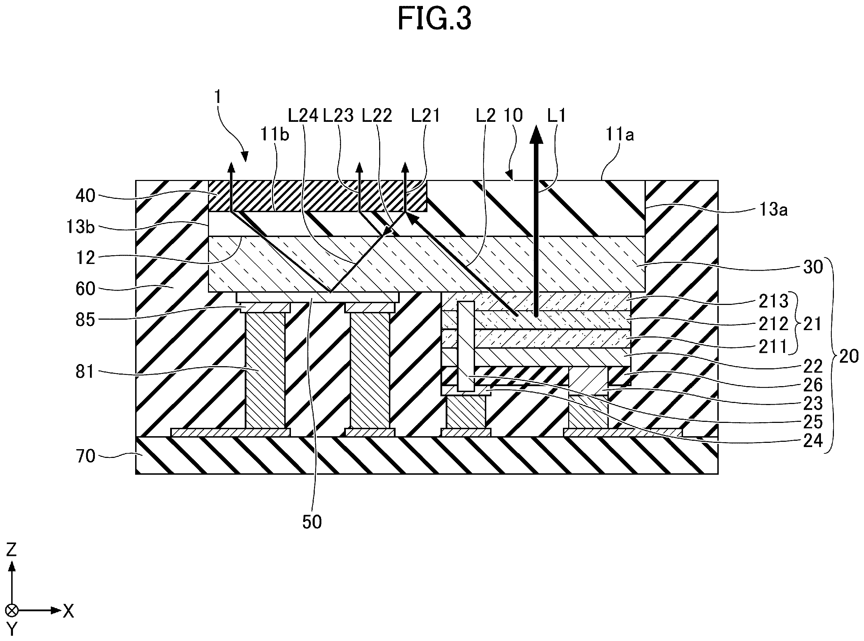

Next, an example of the action of the light emitting device 1 according to the first embodiment is described with reference to FIG. 3. FIG. 3 is a schematic cross-sectional view for explaining an example of the action of the light emitting device 1 according to the first embodiment.

As illustrated in FIG. 3, for example, the light emitting layer 212 emits light L1 traveling upward (that is, to the +Z side) and light L2 traveling to, for example, a region obliquely above the light emitting layer 212 on the -X side. The light L1 passes through the inside of the light transmissive member 30 and the wavelength converting member 10, and is then extracted from the first upper surface 11a of the wavelength converting member 10.

The light L2 reaches, for example, the lower surface of the light adjusting member 40. Herein, a part of the light L2 among the light L21 that reaches the lower surface of the light adjusting member 40 enters the light adjusting member 40 and is extracted from the upper surface of the light adjusting member 40.

The light such as the light L21 extracted from the upper surface of the light adjusting member 40 corresponds to the light directed to the region on a lateral side (for example, the -X side) with respect to the light emitting layer 212. Because no light emitting layer is present below the light adjusting member 40 (that is, in the region where the light adjusting member 40 overlaps with the second upper surface 11b of the wavelength converting member 10 in a top view), the amount of light extracted from the upper surface of light adjusting member 40 is smaller than the amount of light in the light L1 that travels upward from the light emitting layer 212 and extracted from the first upper surface 11a of the wavelength converting member 10. In other words, the luminance of the first upper surface 11a of the wavelength converting member 10 is higher than the luminance of the upper surface of the light adjusting member 40. This can to make the luminance of the first upper surface 11a of the wavelength converting member 10 and the luminance of the upper surface of the light adjusting member 40, which collectively form the light emitting surface of the light emitting device 1, different from each other. In other words, a luminance distribution including a high luminance region and a low-luminance region can be obtained on the light emitting surface of the light emitting device 1.

Next, some other part of the light L2 among the light L22 that reaches the lower surface of the light adjusting member 40 is reflected on the lower surface of the light adjusting member 40, for example. The light L22 reflected on the lower surface of the light adjusting member 40 reaches the lower surface 12 of the wavelength converting member 10. Furthermore, some part of the light L22 among the light L23 that reaches the lower surface 12 of the wavelength converting member 10 is reflected on the lower surface 12 of the wavelength converting member 10 and once again travels to the lower surface of the light adjusting member 40. Further, the light L23 enters the light adjusting member 40 and is extracted from the upper surface of the light adjusting member 40.

In the portion of the wavelength converting member 10 below the light adjusting member 40, like the light L22 and the light L23, light reciprocates between the lower surface of the light adjusting member 40 and the lower surface 12 of the wavelength converting member 10. Accordingly, the optical path length of light traveling in the wavelength converting member 10 is longer than that in the case where the light adjusting member 40 is not disposed. On the other hand, as illustrated in FIGS. 2 and 3, the thickness of the wavelength converting member 10 from the second upper surface 11b to the lower surface 12 is smaller than the thickness from the first upper surface 11a to the lower surface 12. This can reduce the frequency of excitation of light traveling in the portion of the wavelength converting member 10 below the light adjusting member 40. As a result, the chromaticity of the light extracted from the upper surface of the light adjusting member 40 can be adjusted by adjusting the thickness between the second upper surface 11b and the lower surface 12 of the wavelength converting member 10 in the portion of the wavelength converting member 10 below the light adjusting member 40. Therefore, the difference between chromaticity of the light extracted from the upper surface of the light adjusting member 40 and chromaticity of the light extracted from the first upper surface 11a of the wavelength converting member 10 can be reduced.

Subsequently, some other part of the light L24 among the light L22 that reaches the lower surface 12 of the wavelength converting member 10 enters the light transmissive member 30. Thereafter, the light L24 is reflected on the light reflective film 50. Furthermore, the light L24 reflected on the light reflective film 50 passes through the inside of the light transmissive member 30 and the wavelength converting member 10, and reaches the lower surface of the light adjusting member 40. Further, the light L24 enters the light adjusting member 40 and is extracted from the upper surface of the light adjusting member 40. This can further improve the light extraction efficiency of the light emitting device 1.

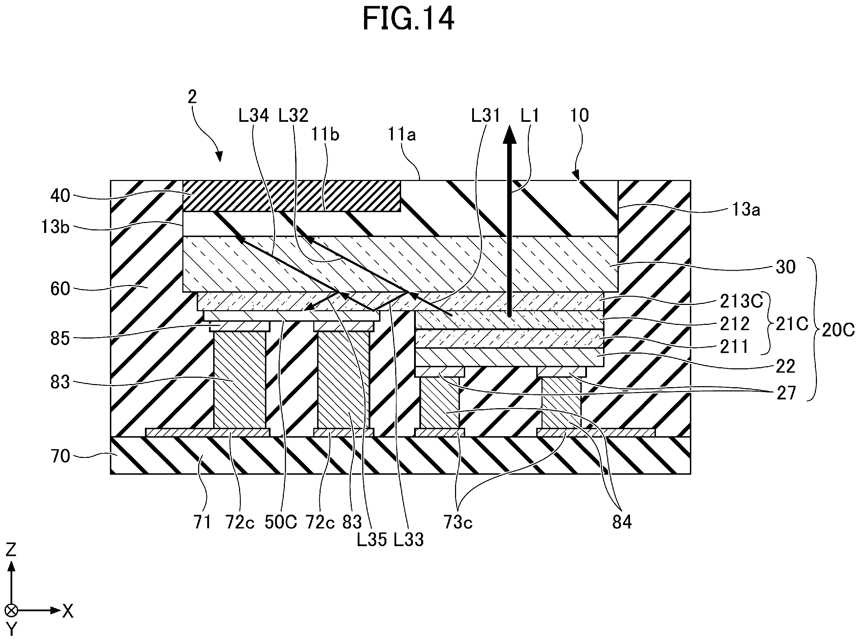

In FIG. 3 and FIG. 14 that is described later, the arrows indicating the traveling direction of light may omit the change in the traveling direction of light caused by the difference in refractive index between the members.

### <Manufacturing Method>

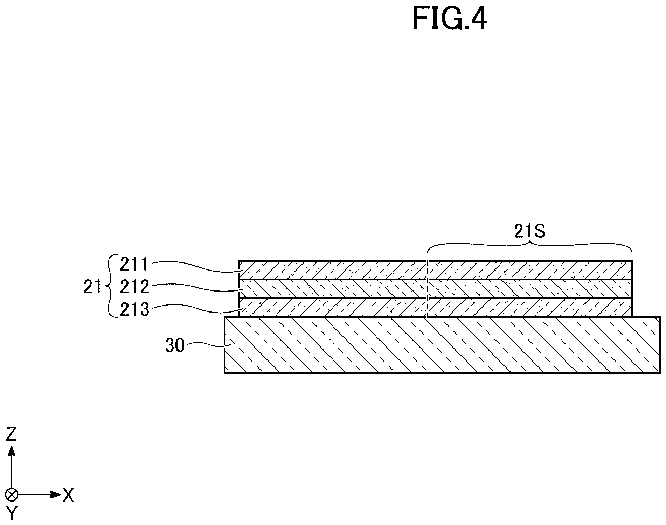

Next, an example of a method for manufacturing the light emitting device 1 according to the first embodiment is described with reference to FIGS. 4 through 10. FIGS. 4 through 10 are cross-sectional views schematically illustrating the method for manufacturing the light emitting device 1 according to the first embodiment.

The method of manufacturing the light emitting device 1 according to the first embodiment includes: a step of providing a first intermediate 110M that includes the light emitting part 21, the light transmissive member 30, and the light reflective film 50; a step of providing a second intermediate 120M that includes the wavelength converting member 10 and the light adjusting member 40; a step of disposing the first intermediate 110M on the wiring substrate 70; a step of disposing the second intermediate 120M above the first intermediate 110M; and a step of forming the covering member 60.

### <Step of Providing First Intermediate 110M>

The step of providing the first intermediate 110M is described. As illustrated in FIG. 4, the light emitting part 21 including the first semiconductor layer 211, the light emitting layer 212, and the second semiconductor layer 213 is formed on the light transmissive member 30. Subsequently, a portion 21S of the light emitting part 21 is removed by a removal method, such as etching. A hole for disposing the second electrode 25 is formed in the light emitting part 21 by a removal method, such as etching.

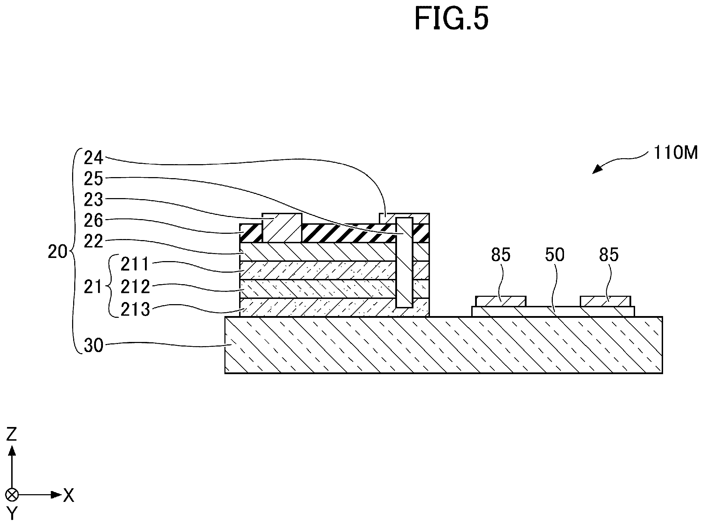

Subsequently, as illustrated in FIG. 5, the first electrode 22, the first pad electrode 23, the second pad electrode 24, the second electrode 25, and the insulating layer 26 are formed on the light emitting part 21 by using a film deposition technique, such as a sputtering method. The light reflective film 50 is formed on the light transmissive member 30 and at a position separated from the light emitting part 21 by using the film deposition technique method, such as a sputtering method. Subsequently, the adhesive layer 85 is formed on the light reflective film 50. The first intermediate 110M is thus provided.

### <Step of Providing Second Intermediate 120M>

Next, the step of providing the second intermediate 120M is described. The step of providing the second intermediate 120M may be performed before or after the step of providing the first intermediate 110M.

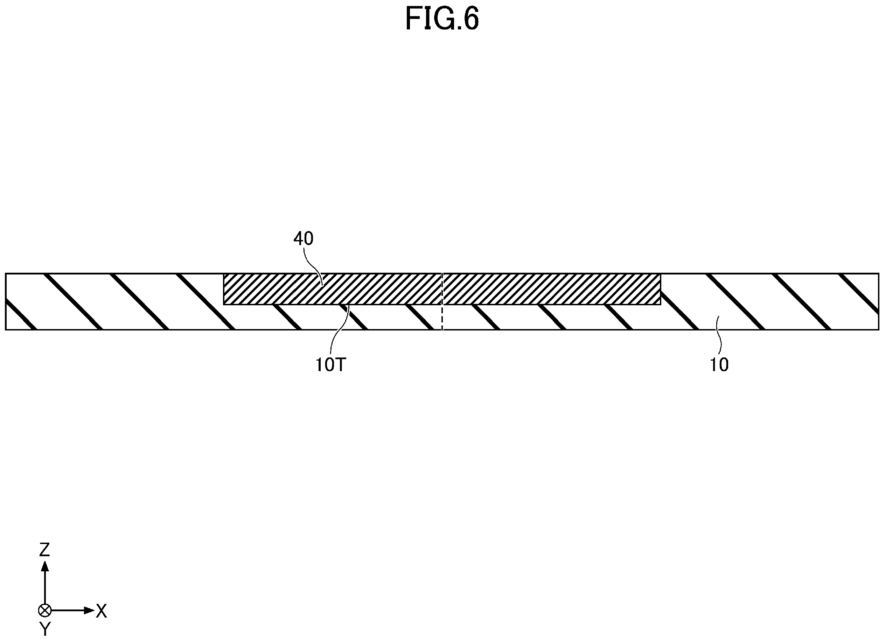

As illustrated in FIG. 6, a groove 10T is formed in the central portion of the wavelength converting member 10 by etching or cutting with a blade. Subsequently, the light adjusting member 40 is disposed in the groove 10T. A plate-like member in which the wavelength converting member 10 and the light adjusting member 40 are monolithic is thereby obtained. As a method of arranging the light adjusting member 40, for example, a method known in the art, such as printing, potting, compression molding using a mold, or transfer molding, can be used.

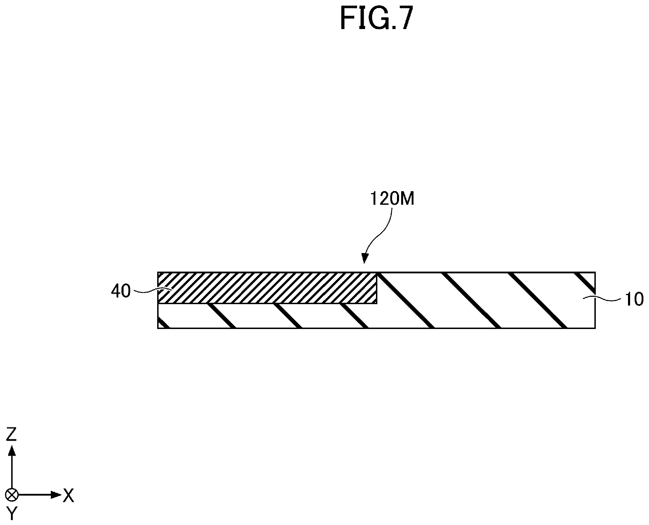

Subsequently, the plate member is cut at a predetermined position (for example, the position indicated by a dashed line in FIG. 6) by a dicing method or the like, and is singulated into the second intermediate 120M as illustrated in FIG. 7. The second intermediate 120M is thereby provided.

### <Step of Arranging First Intermediate 110M on Wiring Substrate 70>

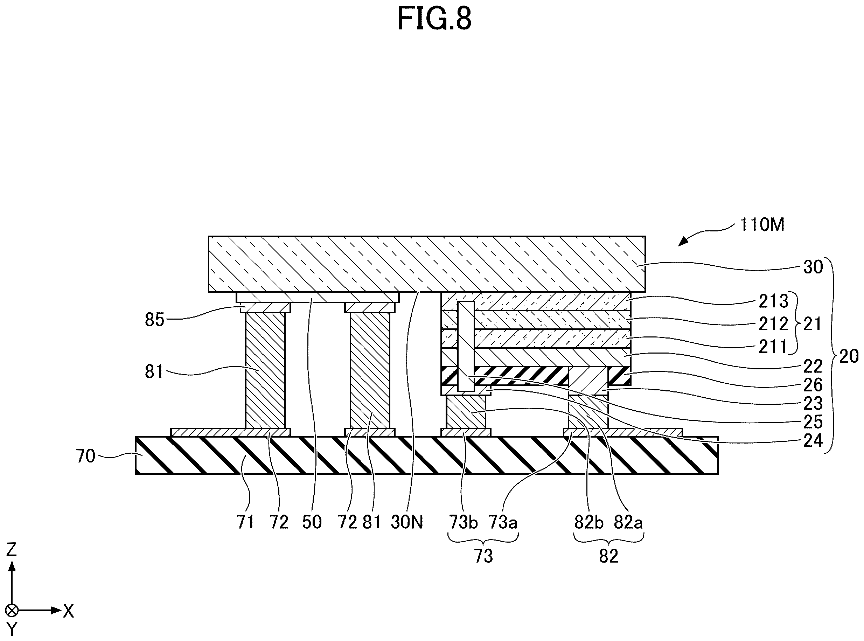

Next, a process of arranging the first intermediate 110M on the wiring substrate 70 is described. As illustrated in FIG. 8, the bonding members 81 and 82 (82a, 82b) are disposed on the wiring substrate 70. At this time, the bonding member 81 is bonded to the first metal layer 72 of the wiring substrate 70. The bonding member 82a is joined to the second metal layer 73a of the wiring substrate 70. The bonding member 82b is joined to the second metal layer 73b of the wiring substrate 70.

The first intermediate 110M is conveyed to a position above the wiring substrate 70 and the bonding members 81 and 82 by using discretionarily chosen conveying means. Thereafter, the bonding member 81 is bonded to the light reflective film 50 via the adhesive layer 85. The bonding member 82 is bonded to the light emitting part 21. The first intermediate 110M is thus disposed above the member including the wiring substrate 70.

### <Step of Disposing Second Intermediate 120M above First Intermediate 110M>

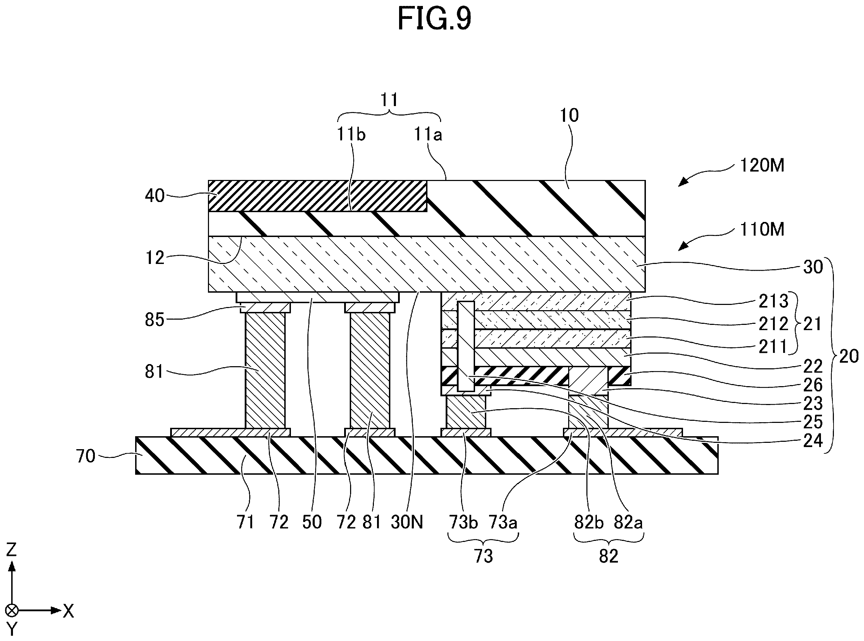

Next, a step of disposing the second intermediate 120M above the first intermediate 110M is described. The second intermediate 120M is conveyed to a position above the light transmissive member 30 using discretionarily chosen conveyance means. Thereafter, as illustrated in FIG. 9, the lower surface 12 of the wavelength converting member 10 is bonded to the upper surface of the light transmissive member 30. The second intermediate 120M is thus disposed above the first intermediate 110M. The wavelength converting member 10 may be directly bonded to the light transmissive member 30, or may be bonded to the light transmissive member 30 via an adhesive member (for example, a light transmissive resin). In the case where the wavelength converting member 10 is directly bonded to the light transmissive member 30, for example, a direct bonding method such as pressure bonding, sintering, surface activation bonding, atomic diffusion bonding, or hydroxyl bonding can be used.

### <Step of Forming Covering Member 60>

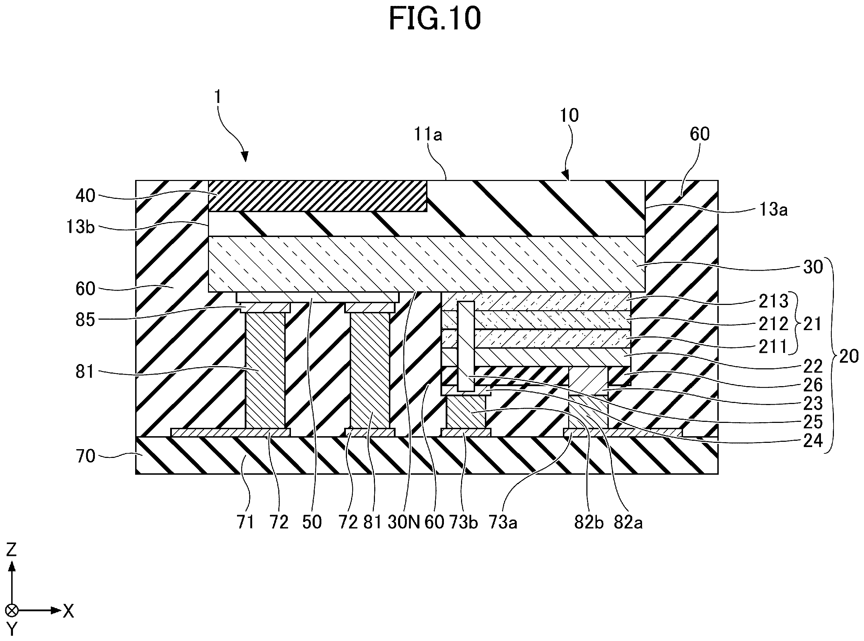

Next, a process of forming the covering member 60 is described. As illustrated in FIG. 10, the covering member 60 is applied so as to cover the first lateral surface 13a and the second lateral surface 13b of the wavelength converting member 10, the portion 30N of the light transmissive member 30, and the outer lateral surfaces of the light adjusting member 40. Subsequently, the covering member 60 is cured by heat treatment. The covering member 60 is thus formed. In the case where the first upper surface 11a of the wavelength converting member 10 and the upper surface of the light adjusting member 40 are covered with the applied covering member 60, the upper end portion of the covering member 60 is polished or ground to expose the first upper surface 11a of the wavelength converting member 10 and the upper surface of the light adjusting member 40.

The light emitting device 1 is manufactured through the above-described steps. In the step of providing the first intermediate 110M described with reference to FIG. 5, the bonding member 81 may be bonded to the adhesive layer 85, and the bonding member 82 may be bonded to the first pad electrode 23 and the second pad electrode 24. The second intermediate 120M may be disposed on the first intermediate 110M before the step of disposing the first intermediate 110M on the wiring substrate 70. At least one of the above-described first intermediate 110M, second intermediate 120M, covering member 60, and wiring substrate 70 can be provided through purchase.

### (Modifications of First Embodiment)

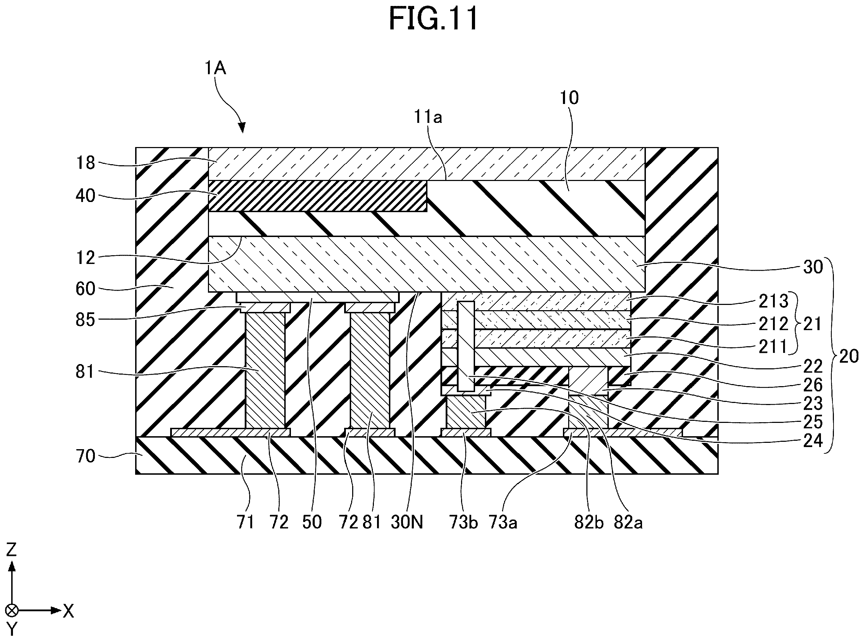

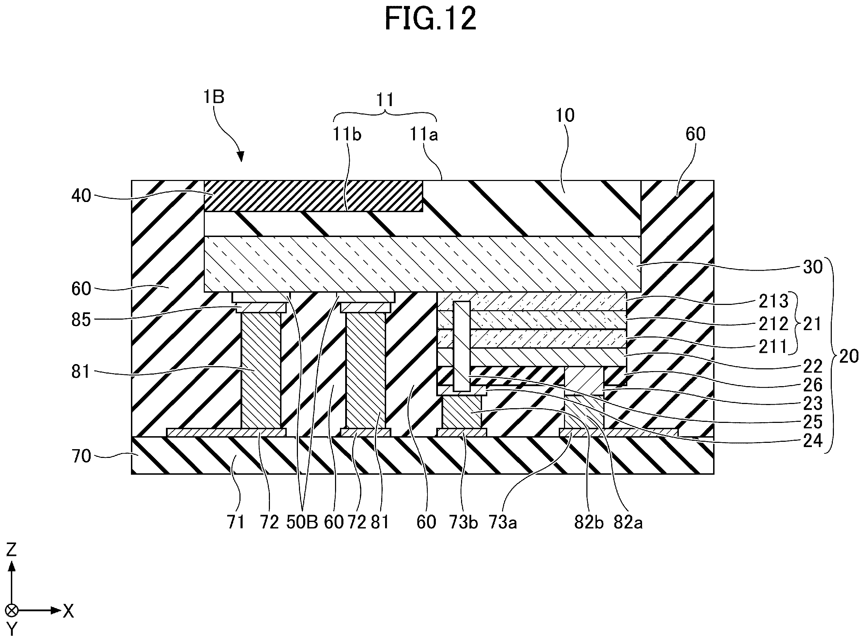

Next, modifications of the light emitting device according to the first embodiment are described with reference to FIGS. 11 and 12. FIG. 11 is a cross-sectional view schematically illustrating a light emitting device 1A according to a modification of the first embodiment. FIG. 12 is a cross-sectional view schematically illustrating a light emitting device 1B according to another modification of the first embodiment. In the modifications of the first embodiment, the same or similar components as those of the first embodiment are denoted by the same reference numerals, and the description thereof will be appropriately omitted.

A configuration example of the light emitting device 1A according to a modification is described. As illustrated in FIG. 11, the light emitting device 1A further includes a light transmissive plate 18 disposed on the first upper surface 11a of the wavelength converting member 10 and the upper surface of the light adjusting member 40. The wavelength converting member 10 and the light adjusting member 40 can be protected by the light transmissive plate 18.

The light transmissive plate 18 may be formed of an insulating material such as sapphire, spinel, or glass, a semiconductor material such as aluminum nitride or silicon carbide, or the like. Among these, glass is preferable because it has high light transmittance and can reduce the cost. Furthermore, by using glass as the substance of the light transmissive plate 18, it is possible to suppress photodegradation and to ensure mechanical strength. Examples of the glass include borosilicate glass and quartz glass.

Next, a configuration example of the light emitting device 1B according to another modification is described. As illustrated in FIG. 12, the light emitting device 1B includes a plurality of light reflective films 50B respectively bonded to the plurality of bonding members 81. The plurality of light reflective films 50B are disposed to be separated from each other. Thus, the covering member 60 can be disposed between the adjacent light reflective films 50B. If the covering member 60 is formed of a substance having a higher reflectance than the light reflective films 50B, such as white resin, light that reaches the light reflective films 50B and the covering member 60 can be reflected more effectively to the light adjusting member 40. This can further improve the light extraction efficiency of the light emitting device 1B.

### (Second Embodiment)

### <Overall Configuration Example of Light Emitting Device 2>

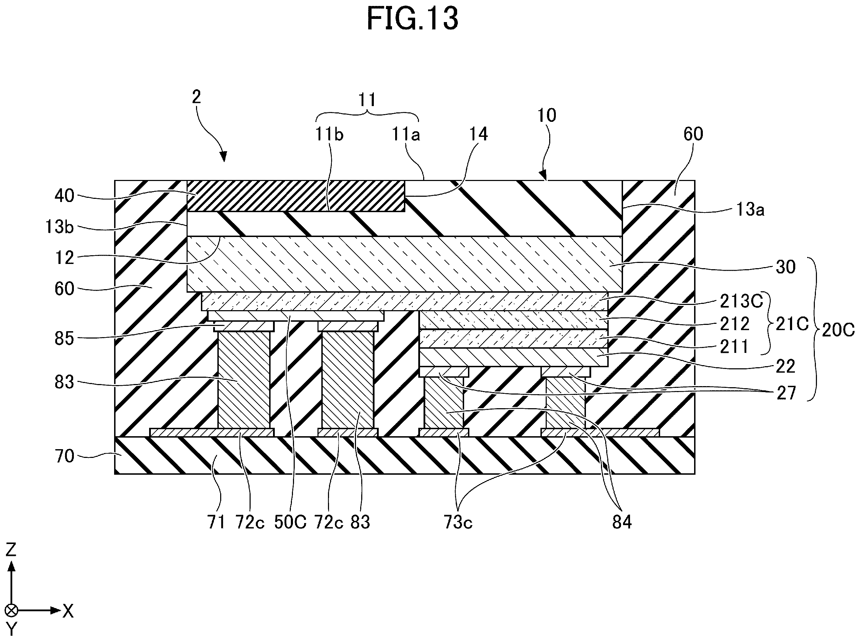

Next, a configuration example of a light emitting device 2 according to the second embodiment is described with reference to FIG. 13. FIG. 13 is a cross-sectional view schematically illustrating an example of the overall configuration of a light emitting device according to the second embodiment. In the example illustrated in FIG. 13, the light emitting device 2 includes a wavelength converting member 10, a light emitting elements 20C including a light emitting part 21C and a light transmissive member 30, and a light adjusting member 40. The light emitting element 20C does not have to include the light transmissive member 30. In the case where the light emitting element 20C does not include the light transmissive member 30, the light emitting device 2 includes the wavelength converting member 10, the light emitting part 21C, and the light adjusting member 40. The light emitting device 2 can further include a light reflective film 50C, a covering member 60, a wiring substrate 70, and bonding members 83 and 84. In the second embodiment, the same reference numerals are given to the same or similar constituent members as those of the first embodiment and the modifications of the first embodiment (hereinafter, the first embodiment and the modifications of the first embodiment are collectively referred to as "first embodiment, etc."), and the description thereof will be omitted as appropriate.

The light emitting part 21C of the light emitting device 2 includes a second semiconductor layer 213C disposed so as to extend to a portion between the light transmissive member 30 and the light reflective film 50C. In other words, the second semiconductor layer 213C overlaps with each of a first upper surface 11a and a second upper surface 11b of the wavelength converting member 10 in a top view.

The light reflective film 50C is bonded to the second semiconductor layer 213C. The light reflective film 50C has conductivity. The light emitting device 2 includes bonding members 83 and 84. The bonding member 83 electrically connects a first metal layer 72c disposed on the upper surface of the wiring substrate 70 and the light reflective film 50C. In the example illustrated in FIG. 13, a conductive adhesive layer 85 is disposed between the bonding member 83 and the light reflective film 50C. The bonding member 84 electrically connects a second metal layer 73c disposed on the upper surface of the wiring substrate 70 and a first semiconductor layer 211. A pad electrode 27 and a first electrode 22 are disposed between the bonding member 84 and a first semiconductor layer 211. The bonding member 83 is an example of a "first bonding member". The bonding member 84 is an example of a "second bonding member".

The first metal layer 72c, the bonding member 83, the light reflective film 50C, the second semiconductor layer 213C, a light emitting layer 212, the first semiconductor layer 211, and the second metal layer 73c are electrically connected to each other. For example, the current from an external power supply is supplied to the light emitting part 21C via the second metal layer 73c. The current supplied to the light emitting part 21C flows to the -X side in the second semiconductor layer 213C of the light emitting part 21C, and then flows to the light reflective film 50C, the adhesive layer 85, the bonding member 83, and the first metal layer 72c in this order. With such a configuration, the current supplied from the second metal layer 73c to the light emitting layer 212 is easily supplied to the entire light emitting layer 212 in a plan view, and thus, the light emitting efficiency of the light emitting layer 212 can be improved.

### <Example of Action>

Next, an example of the action of the light emitting device 2 according to the second embodiment is described with reference to FIG. 14. FIG. 14 is a schematic cross-sectional view for explaining an example of the action of the light emitting device 2 according to the second embodiment.

As illustrated in FIG. 14, light L31 traveling from the light emitting layer 212 to, for example, a region obliquely above the light emitting layer 212 on the -X side reaches the lower surface of the light transmissive member 30. At this time, some part of the light L32 of the light L31 enters the light transmissive member 30. Thereafter, the light L32 passes through the inside of the light transmissive member 30 and the light adjusting member 40, and is extracted from the upper surface of the light adjusting member 40.

On the other hand, some other part of the light L33 of the light L31 is reflected on the lower surface of the light transmissive member 30 and travels to the upper surface of the light reflective film 50C. The light L33 is reflected on the upper surface of the light reflective film 50C and once again reaches the lower surface of the light transmissive member 30. At this time, some part of the light L34 of the light L33 enters the light transmissive member 30. Thereafter, the light L34 passes through the inside of the light transmissive member 30 and the light adjusting member 40, and is extracted from the upper surface of the light adjusting member 40. On the other hand, another part of the light L35 among the light L33 that reaches the lower surface of the light transmissive member 30 is reflected on the lower surface of the light transmissive member 30 and travels to the upper surface of the light reflective film 50C.

According to the second embodiment, the light traveling from the light emitting layer 212 to a portion on a lateral side (for example, the -X side) with respect to the light emitting layer 212 can be extracted from the upper surface of the light adjusting member 40 via the second semiconductor layer 213C extending to the portion between the light transmissive member 30 and the light reflective film 50C. This can improve the light extraction efficiency of the light emitting device 2.

### (Third Embodiment)

### <Overall Configuration Example of Light Emitting Device 3>

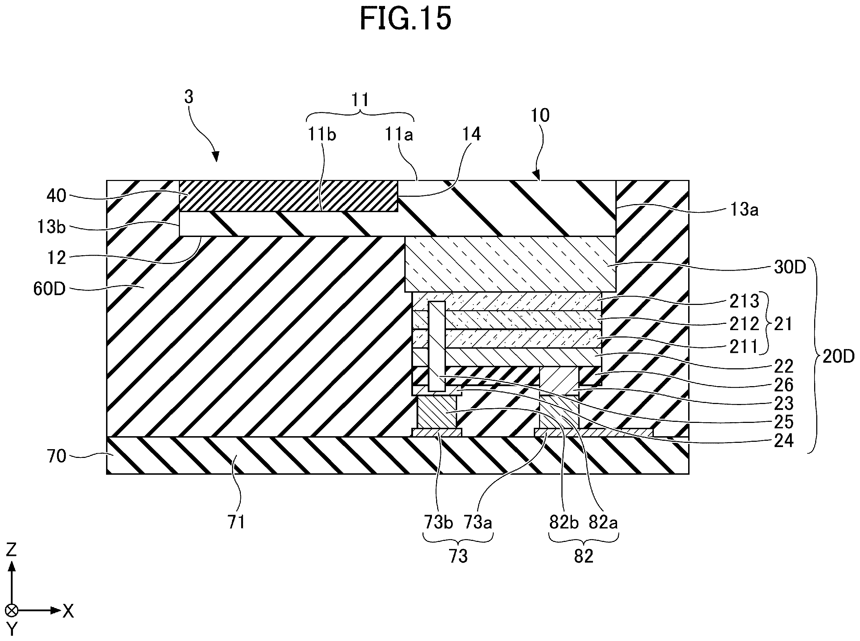

Next, a configuration example of a light emitting device 3 according to the third embodiment is described with reference to FIG. 15. FIG. 15 is a cross-sectional view schematically illustrating an example of the overall configuration of the light emitting device 3 according to the third embodiment. In the example illustrated in FIG. 15, the light emitting device 3 includes a wavelength converting member 10, a light emitting elements 20D including a light emitting part 21 and a light transmissive member 30D, a light adjusting member 40, and a covering member 60D. In the third embodiment, the same or similar components as those of the first embodiment, etc. and the second embodiment are denoted by the same reference numerals, and the description thereof will be appropriately omitted.

The light transmissive member 30D is disposed between the wavelength converting member 10 and the light emitting part 21, similarly to the first embodiment, etc. and the second embodiment. The light transmissive member 30D does not overlap with the light adjusting member 40 in a top view, unlike the first embodiment, etc. and the second embodiment. In other words, the light transmissive member 30D does not overlap with the low-luminance region of the light emitting surface of the light emitting device 3 in a top view.

The covering member 60D covers a first lateral surface 13a and a second lateral surface 13b of the wavelength converting member 10. The covering member 60D has a light reflective property. The covering member 60D covers the lower surface 12 of the wavelength converting member 10in the region that does not overlap with the light emitting part 21 in a top view. In other words, the covering member 60D covers the lower surface 12 of the wavelength converting member 10 in the region that overlaps with the light adjusting member 40 in a top view. As the covering member 60D, a resin containing particles of a light reflective substance can be used. Examples of the light reflective substances and the resins are those listed for the covering member 60 of the first embodiment.

According to the third embodiment, light that is emitted obliquely above on the -X-side from a light emitting layer 212 of the light emitting part 21 located in the high-luminance region and reaches the lateral surface of the light transmissive member 30D, is reflected on the covering member 60D. It is thus possible to reduce an amount of light taken out to the outside from the low-luminance region side and to increase an amount of light taken out to the outside from the high-luminance region. It is thus possible to increase a difference between the luminance of the light emitted from the first upper surface 11a of the wavelength converting member 10 corresponding to the high-luminance region of the light emitting device 3 and the luminance of the light emitted from the upper surface of the light adjusting member 40 corresponding to the low-luminance region of the light emitting device 3. It is also possible to sharply change the luminance in the vicinity of the boundary (i.e., at the inner wall surface 14) between the first upper surface 11a of the wavelength converting member 10 and the upper surface of the light adjusting member 40, namely in the vicinity of an inner wall surface 14.

### (Modifications of Third Embodiment)

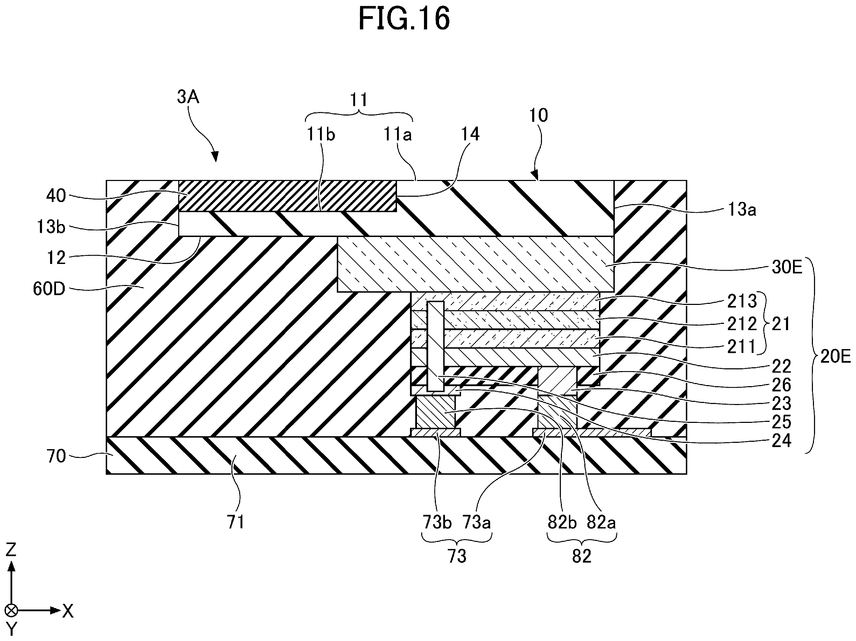

Next, modifications of the light emitting device 3 according to the third embodiment are described with reference to FIG. 16. FIG. 16 is a cross-sectional view schematically illustrating a light emitting device 3A according to a modification of the third embodiment. In the modification of the third embodiment, the same or similar components as those of the first embodiment, etc. and the second and third embodiments are denoted by the same reference numerals, and the description thereof will be appropriately omitted.

In the light emitting device 3A according to the modification, a light emitting element 20E includes a light transmissive member 30E. The modification differs from the third embodiment mainly in that the light transmissive member 30E overlaps with a part of the light adjusting member 40 in a top view, as illustrated in FIG. 16. Specifically, the lateral surface on the -X side of the light transmissive member 30E is located further on the -X side relative to the inner wall surface 14 of the wavelength converting member 10, and is located further on the +X side than the second lateral surface 13b of the wavelength converting member 10.

Because the light transmissive member 30E overlaps with a part of the light adjusting member 40 in a top view, the change in luminance in the vicinity of the boundary between the first upper surface 11a of the wavelength converting member 10 and the upper surface of the light adjusting member 40 can be made more gradual than that in the third embodiment.

### (Fourth Embodiment)

### <Overall Configuration Example of Light Emitting Device 4>

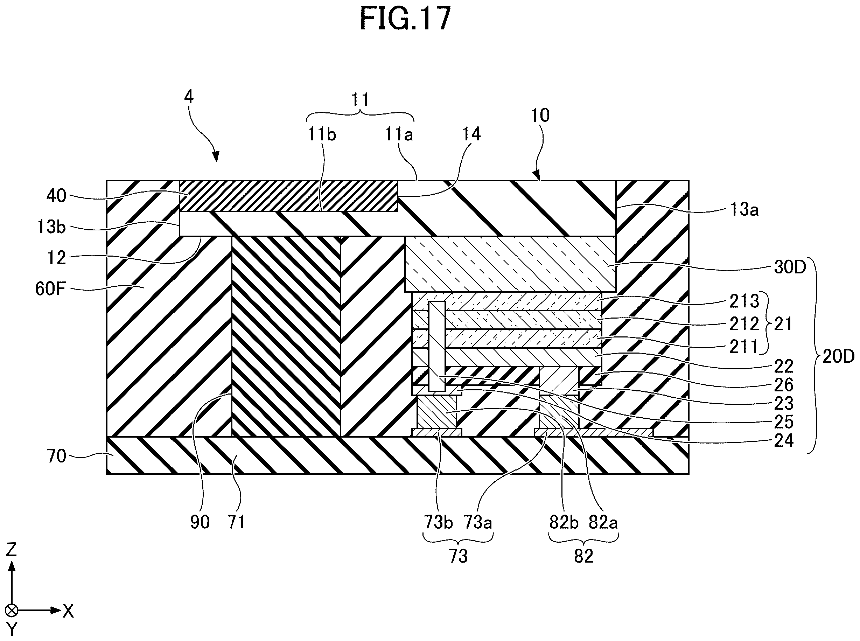

Next, a configuration example of a light emitting device 4 according to the fourth embodiment is described with reference to FIG. 17. FIG. 17 is a cross-sectional view schematically illustrating an example of the overall configuration of the light emitting device 4 according to the fourth embodiment. In the example illustrated in FIG. 17, the light emitting device 4 includes a wavelength converting member 10, a light emitting elements 20D including a light emitting part 21 and a light transmissive member 30D, a light adjusting member 40, a covering member 60F, a wiring substrate 70, and a supporting body 90. In the fourth embodiment, the same reference numerals are given to the same or similar constituent members as those of the first embodiment, the second embodiment, the third embodiment and the modifications of the third embodiment (hereinafter, the third embodiment and the modifications of the third embodiment are collectively referred to as "third embodiment, etc."), and the description thereof will be omitted as appropriate.

The wiring substrate 70 is electrically connected to the light emitting part 21, similarly to the first embodiment, etc. through the third embodiment, etc. The supporting body 90 is disposed on the wiring substrate 70 and supports the wavelength converting member 10. An adhesive member may be or does not have to be disposed between the lower surface of the supporting body 90 and the upper surface of the wiring substrate 70. An adhesive member may be or does not have to be disposed between the upper surface of the supporting body 90 and a lower surface 12 of the wavelength converting member 10. The covering member 60F covers a first lateral surface 13a and a second lateral surface 13b of the wavelength converting member 10, and covers the lower surface 12 of the wavelength converting member 10 at the portions exposed from the supporting body 90 and the light emitting element 20D.

Examples of the supporting body 90 include a member formed of a metal material listed for the bonding member 81 of the first embodiment, a member formed of ceramics such as aluminum nitride and silicon carbide, a member formed of a light transmissive material such as sapphire, spinel, and glass, and a member formed of a white resin containing light reflective particles and a resin. If the supporting body 90 is formed of a white resin, the supporting body 90 may be formed of the same resin as that constituting the covering member 60D of the third embodiment or a different resin.

If the supporting body 90 is formed of a light reflective member, such as a metal material or a white resin, the supporting body 90 can reflect light laterally emitted from the light emitting layer 212 of the light emitting part 21 to the wavelength converting member 10 side. This can improve the light extraction efficiency of the light emitting device 4. If the supporting body 90 is formed of ceramics, such as aluminum nitride and silicon carbide, the supporting body 90 can effectively release heat generated in the wavelength converting member 10 to the wiring substrate 70 side.

The covering member 60F covers the first lateral surface 13a and the second lateral surface 13b of the wavelength converting member 10. The covering member 60F has a light reflective property. The covering member 60F covers the lower surface 12 of the wavelength converting member 10 in the region that does not overlap with the light emitting part 21 in a top view. The covering member 60F covers the lateral surface of the supporting body 90. As the covering member 60F, a resin containing light reflective particles same as or similar to the resin constituting the covering member 60D of the third embodiment can be used.

According to the fourth embodiment, the supporting of the wavelength converting member 10 by the supporting body 90 can reduce a possibility that the wavelength converting member 10 is tilted with respect to the light emitting part 21 by the self-weight of the wavelength converting member 10

### (Modifications of Fourth Embodiment)

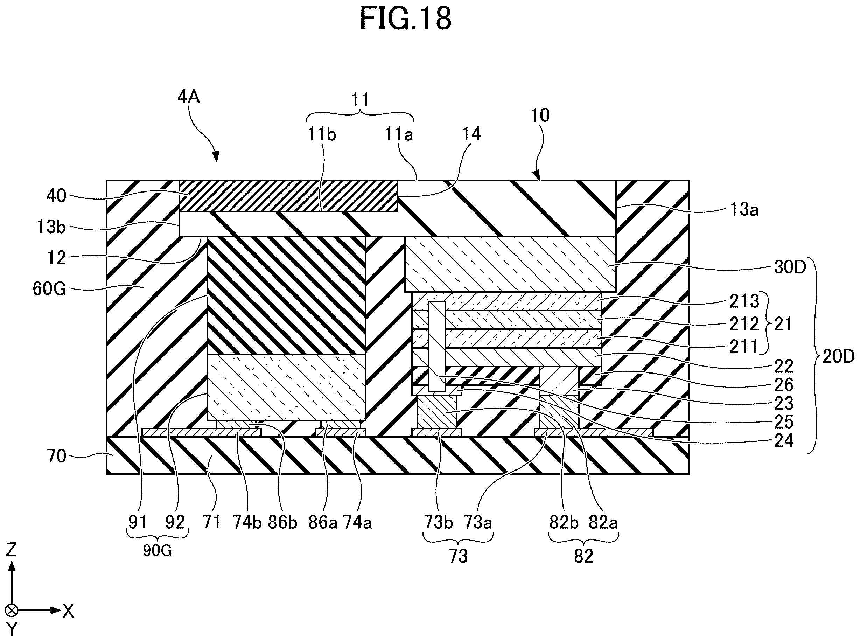

Next, modifications of the light emitting device 4 according to the fourth embodiment are described with reference to FIG. 18. FIG. 18 is a cross-sectional view schematically illustrating a light emitting device 4A according to a modification of the fourth embodiment. In the modification of the fourth embodiment, the same or similar components as those of the first embodiment, etc., the second embodiment, the third embodiment, etc., and the fourth embodiment are denoted by the same reference numerals, and the description thereof will be appropriately omitted.

The light emitting device 4A according to the modification differs from the fourth modification mainly in that a supporting body 90G is formed of a light reflective member 91 and a protecting element 92. The protecting element 92 is an element for protecting the light emitting element 20D from element breakage or performance deterioration due to an excessive voltage application. The protecting element 92 is for example a Zener diode that is brought into a conductive state upon application of a voltage larger than a specified voltage. The protecting element 92 is disposed on the wiring substrate 70. Specifically, the protecting element 92 is electrically connected to third metal layers 74a and 74b of the wiring substrate 70 via third bonding members 86a and 86b. The light reflective member 91 is disposed on the protecting element 92. It is thereby possible to reduce light absorption by the protecting element 92. The light reflective member 91 is formed of a white resin, for example. The light reflective member 91 may be disposed on the protecting element 92, with or without an adhesive member being interposed therebetween.

As illustrated in FIG. 18, the covering member 60G covering a first lateral surface 13a and a second lateral surface 13b of the wavelength converting member 10 covers the lateral surface of the light reflective member 91 and the lateral surface of the protecting element 92. With the lateral surface of the protecting element 92 being covered by the covering member 60G, light laterally emitted from the light emitting layer 212 of the light emitting part 21 is reflected on the covering member 60G before the light reaches the protecting element 92, and travels to the wavelength converting member 10 side. In other words, the light laterally emitted from the light emitting layer 212 of the light emitting part 21 is not absorbed by the protecting element 92. This can improve the light extraction efficiency of the light emitting device 4A.

### (Fifth Embodiment)

### <Overall Configuration Example of Light Emitting Device 5>

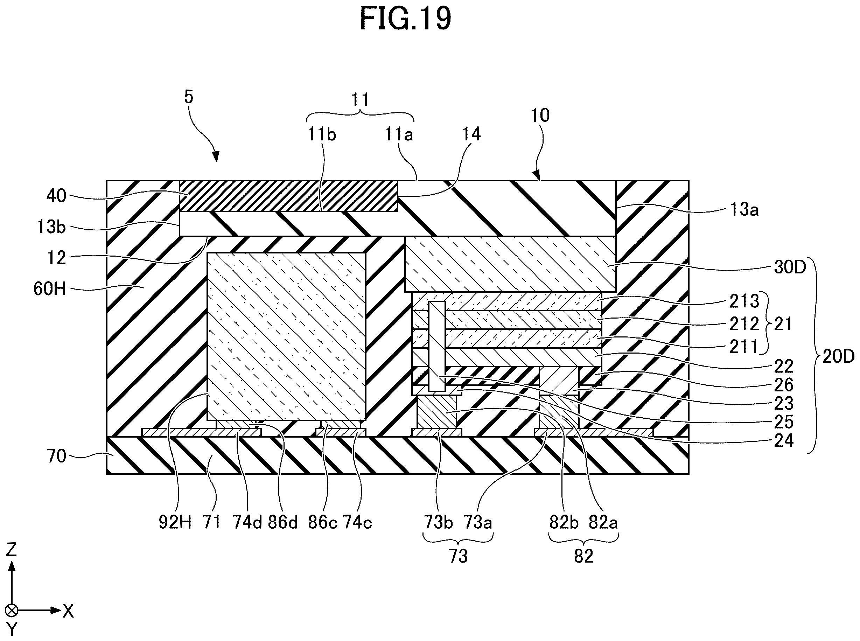

Next, a configuration example of a light emitting device 5 according to the fifth embodiment is described with reference to FIG. 19. FIG. 19 is a cross-sectional view schematically illustrating an example of the overall configuration of the light emitting device 5 according to the fifth embodiment. In the example illustrated in FIG. 19, the light emitting device 5 includes a wavelength converting member 10, a light emitting elements 20D including a light emitting part 21 and a light transmissive member 30D, a light adjusting member 40, a covering member 60H, a wiring substrate 70, and a protecting element 92H.

As illustrated in FIG. 19, the protecting element 92H is disposed on the wiring substrate 70. Specifically, the protecting element 92H is electrically connected to third metal layers 74c and 74d of the wiring substrate 70 via third bonding members 86c and 86d. The protecting element 92H is disposed on the wiring substrate 70 in the region that overlaps with the light adjusting member 40 in a top view. The upper surface, lower surface, and lateral surface of the protecting element 92H are covered with the covering member 60H. Accordingly, light laterally emitted from a light emitting layer 212 of the light emitting part 21 is reflected on the covering member 60H before the light reaches the protecting element 92H, and travels to the wavelength converting member 10 side. In other words, the light laterally emitted from the light emitting layer 212 of the light emitting part 21 is not absorbed by the protecting element 92H. This can improve the light extraction efficiency of the light emitting device 5.

A lower surface 12 of the wavelength converting member 10 and the upper surface of the protecting element 92H are separated. A part of the covering member 60H is located between the lower surface 12 of the wavelength converting member 10 and the upper surface of the protecting element 92H. The thickness of the covering member 60H located between the lower surface 12 of the wavelength converting member 10 and the upper surface of the protecting element 92H is thinner than the thickness of the light transmissive member 30D. It is thereby possible to shorten the distance between the upper surface of the protecting element 92H and the lower surface 12 of the wavelength converting member 10. As a result, if the wavelength converting member 10 is slanted, it is possible to suppress a tilt of the wavelength converting member 10 with respect to the light emitting part 21 greater than a predetermined angle. It is also possible to reduce the possibility that the luminance distribution and chromaticity of light emitted from the light emitting device 5 would deviate from desired luminance distribution and chromaticity. Unlike the example illustrated in FIG. 19, the upper surface of the protecting element 92H may be in contact with the lower surface 12 of the wavelength converting member 10.

### <Examples>

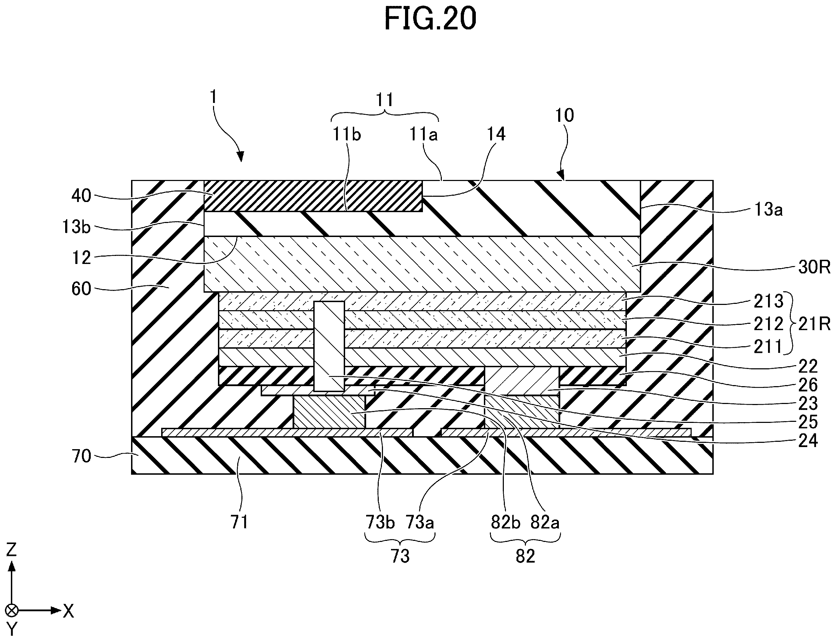

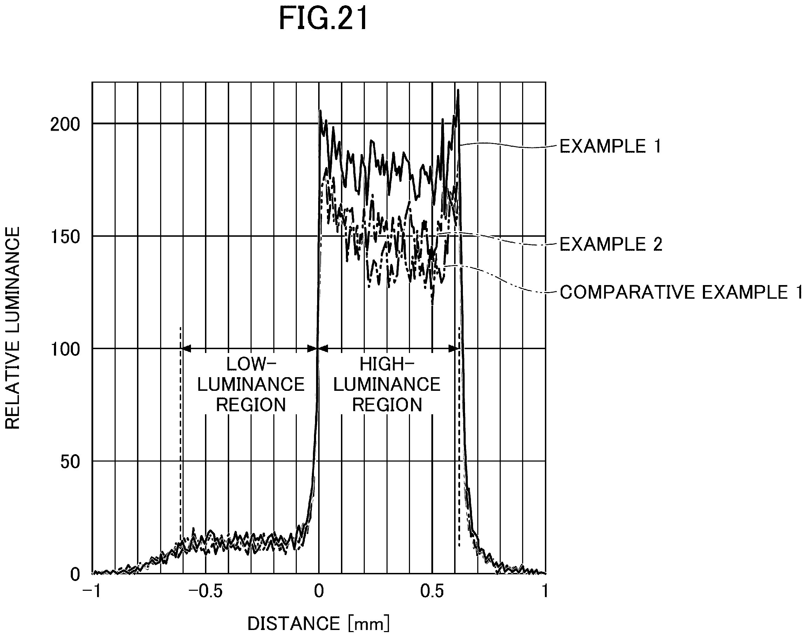

The luminance and luminous flux of light emitted from the light emitting surface in each of Example 1, Example 2, and Comparative Example 1 were calculated using an optical simulation software (an optical design software "LightTools" (registered trademark) manufactured by Synopsys, Inc.). Results of the optical simulation for Example 1, Example 2, and Comparative Example 1 are explained hereinafter with reference to FIGS. 20 and 21 and Table 1. In the optical simulation, the same power was supplied to emit light in Example 1, Example 2, and Comparative Example 1.

Example 1 has the same configuration as the light emitting device 3 of the third embodiment. The light transmissive member 30D of Example 1 overlaps with the first upper surface 11a of the wavelength converting member 10 and does not overlap with the light adjusting member 40 in a top view. Example 2 has the same configuration as the light emitting device 1 of the first embodiment except for the absence of the light reflective film 50, the bonding members 81, and the adhesive layers 85. The light transmissive member 30 of Example 2 overlaps with the first upper surface 11a of the wavelength converting member 10 and the light adjusting member 40 in a top view.

The configuration of Comparative Example 1 is described with reference to FIG. 20. FIG. 20 is a cross-sectional view schematically illustrating the light emitting device 1R according to Comparative Example 1. As illustrated in FIG. 20, Comparative Example 1 includes a light transmissive member 30R having the same configuration as Example 2. In other words, the light transmissive member 30R of Comparative Example 1 overlaps with the first upper surface 11a of the wavelength converting member 10 and the light adjusting member in a top view.

Comparative Example 1 includes a light emitting part 21R disposed below the light transmissive member 30R. The light emitting part 21R overlaps with the first upper surface 11a of the wavelength converting member 10 and the light adjusting member 40 in a top view. In other words, the first semiconductor layer 211, the light emitting layer 212, and the second semiconductor layer 213 of the light emitting part 21R overlap with the first upper surface 11a of the wavelength converting member 10 and the light adjusting member 40 in a top view. Comparative Example 1 further includes the first electrode 22, the first pad electrode 23, the second pad electrode 24, the second electrode 25, and the insulating layer 26. The first electrode 22 is electrically connected to the first semiconductor layer 211. The first electrode 22 is electrically connected to the second metal layer 73a of the wiring substrate 70 via the first pad electrode 23 and the bonding member 82a. The second electrode 25 is electrically connected to the second semiconductor layer 213 via the second pad electrode 24. The second electrode 25 is electrically connected to the second metal layer 73b via the boding member 82b.

Results of the optical simulation for Example 1, Example 2, and Comparative Example 1 are explained hereinafter with reference to FIG. 21 and Table 1. FIG. 21 is a graph illustrating a relative luminance, which is results of optical simulations in Example 1, Example 2, and Comparative Example 1. Table 1 shows values of a relative luminance and a relative luminous flux in a high-luminance region in each of Example 1, Example 2, and Comparative Example 1.

The horizontal axis of FIG. 21 represents a distance in the X-axis direction from the boundary (i.e., at the inner wall surface 14 of the wavelength converting member 10) between the first upper surface 11a of the wavelength converting member 10 (corresponding to the high-luminance region) and the upper surface of the light adjusting member 40 (corresponding to the low-luminance region, namely the inner wall surface 14 of the wavelength converting member 10) in the light emitting surface of each of the light emitting devices. The vertical axis of FIG. 21 represents a relative luminance in Example 1, Example 2, and Comparative Example 1.

As illustrated in FIG. 21, the luminance of the high-luminance region was highest in Example 1, followed by Example 2, and then Comparative Example 1. As shown in Table 1, the value of the luminous flux was highest in the Example 1, followed by Example 2, and then Comparative Example 1.

**[Table 1]**

| | Example 1 | Example 2 | Comparative Example 1 |
|---|---|---|---|
| Relative luminance | 129.1% | 110.0% | 100% |
| Relative luminous flux | 122.6% | 102.4% | 100% |

The results of the optical simulation shown in FIG. 21 and Table 1 demonstrate that, by arranging the light transmissive member 30D so as not to overlap with the light adjusting member 40 in a top view, high luminance light can be emitted from the first upper surface 11a of the wavelength converting member 10, which correspond to the high-luminance region, and a luminance difference between the high-luminance region and the low-luminance region can be increased.

Although the preferred embodiments and the like have been described in detail above, the present invention is not limited to the above-described embodiments and the like, and various modifications and substitutions can be made to the above-described embodiments and the like without departing from the scope described in the claims.

### REFERENCE SIGNS LIST

1, 1A, 1B, 2, 3, 3A, 4, 4A, 5 Light emitting device
10 Wavelength converting member
11 Upper surface
11a First upper surface
11b Second upper surface
12 Lower surface
13a First lateral surface
13b Second lateral surface
20, 20C, 20D, 20E Light emitting element
21, 21C Light emitting part
211 First semiconductor layer
212 Light emitting layer
213, 213C Second semiconductor layer
30, 30D, 30E Light transmissive member
40 Light adjusting member
50, 50B, 50C Light reflecting film
60, 60D, 60F, 60G, 60H Covering member
70 Wiring substrate
71 Base
72, 72c First metal layer
73, 73a, 73b 73c Second metal layer
74A, 74b, 74c, 74d Third metal layer
81, 82, 83, 84 Bonding member
86a, 86b, 86c, 86d Third bonding member
90, 90G Supporting body
91 Light reflective member
92, 92H Protecting element

## Claims

1. A light emitting device comprising:
a wavelength converting member that includes
an upper surface,
a lower surface located opposite to the upper surface,
a first lateral surface located between the upper surface and the lower surface, and
a second lateral surface located between the upper surface and the lower surface, and located opposite to the first lateral surface;
a light emitting part including a light emitting layer, the light emitting part being disposed below the lower surface of the wavelength converting member and in a region closer to the first lateral surface than to the second lateral surface; and
a light adjusting member disposed on the upper surface of the wavelength converting member and in a region closer to the second lateral surface than to the first lateral surface without overlapping with the light emitting layer of the light emitting part in a top view.

2. The light emitting device of claim 1, further comprising
a light transmissive member disposed between the wavelength converting member and the light emitting part, and extending to a region overlapping with the light adjusting member in the top view.

3. The light emitting device of claim 2, wherein
the upper surface of the wavelength converting member includes a first upper surface and a second upper surface positioned lower than the first upper surface,
the light adjusting member is disposed on the second upper surface, and
a thickness of the wavelength converting member from the second upper surface to the lower surface is smaller than a thickness of the wavelength converting member from the first upper surface to the lower surface.

4. The light emitting device of claim 2 or 3, further comprising
a light reflective film disposed below a lower surface of the light transmissive member in the region overlapping with the light adjusting member in the top view.

5. The light emitting device of claim 4, further comprising
a covering member having a light reflective property, and covering the first lateral surface and the second lateral surface of the wavelength converting member, wherein
the covering member covers a portion of the lower surface of the light transmissive member that does not overlap with the light reflective film in the top view.

6. The light emitting device of claim 4 or 5, further comprising:
a wiring substrate disposed below the light emitting part and the light reflective film, and including a first metal layer on an upper layer of the wiring substrate; and
a first bonding member that connects the first metal layer to the light reflective film.

7. The light emitting device of claim 6, wherein the first bonding member includes at least one of a metal material or an alloy material.

8. The light emitting device of any one of claims 4 to 7, wherein
the light emitting part further includes a first semiconductor layer and a second semiconductor layer, the first semiconductor layer being disposed on a lower surface of the light emitting layer, and the second semiconductor layer being disposed on an upper surface of the light emitting layer, and
the second semiconductor layer extends to a region between the light transmissive member and the light reflective film.

9. The light emitting device of claim 8, wherein
the light reflective film has conductivity, and
the light emitting device further includes
a wiring substrate disposed below the light emitting part and the light reflective film, and including a first metal layer and a second metal layer on an upper layer of the wiring substrate,
a first bonding member that electrically connects the first metal layer to the light reflective film, and
a second bonding member that electrically connects the second metal layer to a lower surface of the first semiconductor layer.

10. The light emitting device of any one of claims 1 to 9, wherein
the light emitting part includes a plurality of additional light emitting layers.

11. The light emitting device of claim 1, further comprising
a light transmissive member disposed between the wavelength converting member and the light emitting part and not overlapping with the light adjusting member in the top view.

12. The light emitting device of claim 11, further comprising
a covering member covering the first lateral surface and the second lateral surface of the wavelength converting member, and having a light reflective property, wherein
the covering member covers a portion of the lower surface of the wavelength converting member that does not overlap with the light emitting part in the top view.

13. The light emitting device of claim 12, further comprising:
a wiring substrate electrically connected to the light emitting part; and
a supporting body disposed on the wiring substrate and supporting the wavelength converting member.

14. The light emitting device of claim 13, wherein
the supporting body is formed of a light reflective member.

15. The light emitting device of claim 13, wherein
the supporting body is formed of a light reflective member and a protecting element,
the protecting element is disposed on the wiring substrate, and
the light reflective member is disposed on the protecting element.

16. The light emitting device of claim 12, further comprising:
a wiring substrate electrically connected to the light emitting part; and
a protecting element disposed on a portion of the wiring substrate overlapping with the light adjusting member in the top view, the protecting element being covered by the covering member, wherein
the lower surface of the wavelength converting member is spaced apart from an upper surface of the protecting element, and
a thickness of a portion of the covering member located between the lower surface of the wavelength converting member and the upper surface of the protecting element is smaller than a thickness of the light transmissive member.
